(19) Europäisches Patentamt
European Patent Office
Office européen des brevets

(11) **EP 3 096 438 A1**

(12) **EUROPEAN PATENT APPLICATION**
published in accordance with Art. 153(4) EPC

(43) Date of publication:
**23.11.2016 Bulletin 2016/47**

(51) Int Cl.:
**H02J 50/00** (2016.01)

(21) Application number: **15737543.7**

(22) Date of filing: **13.01.2015**

(86) International application number:
**PCT/JP2015/050655**

(87) International publication number:
**WO 2015/108030 (23.07.2015 Gazette 2015/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.01.2014 JP 2014004268**

(71) Applicant: **Nitto Denko Corporation Ibaraki-shi, Osaka 567-8680 (JP)**

(72) Inventors:
• **TSUDA, Hisashi**
  **Ibaraki-shi, Osaka 567-8680 (JP)**
• **HATANAKA, Takezo**
  **Ibaraki-shi, Osaka 567-8680 (JP)**

(74) Representative: **Müller-Boré & Partner Patentanwälte PartG mbB Friedenheimer Brücke 21 80639 München (DE)**

(54) **WIRELESS ELECTRIC POWER TRANSMISSION DEVICE AND MANUFACTURING METHOD THEREFOR**

(57) The invention enables changes in an input impedance value of a wireless electric power transmission device, according to a load fluctuation tendency of an electric device to which electric power is supplied. The transmission characteristic for transmission between a power-feeding resonator and a power-receiving resonator of this wireless electric power transmission device has two peak bands. The power supply frequency of electric power to a power-feeding module of the wireless electric power transmission device is set to a power supply frequency band that corresponds to either one of the two peak bands of the transmission characteristic (S21), and the input impedance value of the wireless electric power transmission device including the power-supplied electric device at least for the power supply frequencies of the electric power is set so as to have two peak bands with respect to the maximum value of a load fluctuation range of the power-supplied electric device.

FIG.2

$$I_{in} = V_{in} / Z_{in}$$

EP 3 096 438 A1

**Description**

[TECHNICAL FIELD]

The present invention relates to a wireless power transmission apparatus configured to supply power from a power-supplying module to a power-receiving module by varying a magnetic field, and relates to a manufacturing method of such a wireless power transmission apparatus.

[BACKGROUND ART]

Portable electronic devices such as laptop PCs, tablet PCs, digital cameras, mobile phones, portable gaming devices, earphone-type music players, wireless headsets, hearing aids, recorders, which are portable while being used by the user are rapidly increasing in recent years. Many of these portable electronic devices have therein a rechargeable battery, which requires periodical charging. To facilitate the work for charging the rechargeable battery mounted in an electronic device, there are an increasing number of devices for charging rechargeable batteries by using a power-supplying technology (wireless power transmission technology performing power transmission by varying the magnetic field) that performs wireless power transmission between a power-supplying module mounted in a charger and a power-receiving module mounted in an electronic device.

For example, as a wireless power transmission technology, there have been known, for example, a technology that performs power transmission by means of electromagnetic induction between coils (e.g. see PTL 1), a technology that performs power transmission by means of resonance phenomenon (magnetic field resonant state) between resonators (coils) provided to the power-supplying module and the power-receiving module (e.g. see PTL 2).

Further, a constant current/constant voltage charging system is known as the system of charging a rechargeable battery (e.g., lithium ion secondary battery). However, in cases of charging a lithium ion secondary battery with a constant current/constant voltage charging system, in a wireless power transmission apparatus that performs the wireless power transmission, the value of input current supplied is attenuated and the load impedance of a device to be powered (including a rechargeable battery, a stabilizer circuit, a charging circuit, and the like; hereinafter, target device) including the rechargeable battery rises (load fluctuation), when transition occurs from constant current charging (CC) to constant voltage charging (CV).

This will lead to fluctuation in the input impedance of the entire wireless power transmission apparatus including the target device. If it is possible to raise the input impedance of the entire wireless power transmission apparatus including the target device, with an increase in the load impedance of the target device, it is possible to reduce an input current to the wireless power transmission apparatus including the target device, thus enabling reduction of the power consumption of the wireless power transmission apparatus including the target device.

To raise the input impedance of the entire wireless power transmission apparatus including the target device, with an increase in the load impedance of the target device, an approach is to separately providing an impedance matching box.

Citation List

[Patent Literature]

[PTL 1] Japanese patent No. 4624768
[PTL 2] Japanese Unexamined Patent Publication No. 2013-239692

Summary of Invention

Technical Problem

However, separately providing an impedance matching box causes an increases in the number of components, and is inconvenient in portable electronic devices for which portability, compactness, and cost-efficiency are required.

In other words, it is desirable to raise the input impedance of the entire wireless power transmission apparatus including the target device according to an increase in the load impedance of the target device, without an additional device to the wireless power transmission apparatus.

In view of the above, it is an object of the present invention to provide a wireless power transmission apparatus capable of varying the input impedance of the entire wireless power transmission apparatus including a target device, when the load of the target device varies, according to a tendency of variation in the load of the target device, without an additional device. It is a further object to provide a manufacturing method for such a wireless power transmission apparatus.

Solution to Problem

An aspect of the present invention to achieve the above objects is a wireless power transmission apparatus configured to supply power from a power-supplying module to a power-receiving module by varying a magnetic field, the power-supplying module comprising at least a power-supplying resonator, the power-receiving module comprising at least a power-receiving resonator, the power-receiving module connected to a device to be powered (hereinafter, also referred to as target device) with variable load, wherein

a transmission characteristic, of the power-supplying resonator and the power-receiving resonator, with respect to the power-source frequency of the power has two peak bands, and the power-source frequency of the power supplied to the power-supplying module is set to a power-source frequency band corresponding to either one of the two peak bands of the transmission characteristic, and

setting is carried out so that, when the load in the device to be powered is at its maximum value within its load fluctuation range, the input impedance of the wireless power transmission apparatus including the device to be powered, with respect to the power-source frequency of the power has at least two peak bands.

With the above structure, the value of the input impedance of the entire wireless power transmission apparatus including the target device is varied according to the fluctuation tendency of the load of the target device, when the load of the target device is varied. For example, when the load of the target device rises, it is possible to raise the value of input impedance of the entire wireless power transmission apparatus including the target device. Thus, when the load of the target device rises, the input current to the wireless power transmission apparatus including the target device is reduced. This enables reduction of the power consumption when the load of the target device is increased.

Another aspect of the present invention is the wireless power transmission apparatus, adapted so that element values of a plurality of circuit elements constituting the power-supplying module and the power-receiving module are used as parameters, and the parameters are varied so that the transmission characteristic with respect to the driving frequency in the power-supplying resonator and the power-receiving resonator has two peak bands, and that the input impedance of the wireless power transmission apparatus including the device to be powered with respect to the power-source frequency of the power has two peak bands.

The above structure allows a setting that achieves two peak bands in the transmission characteristic with respect to the power-source frequency of the power in the power-supplying resonator and the power-receiving resonator, and two peak bands in the input impedance of the wireless power transmission apparatus, by mutually adjusting element values of circuit elements constituting the power-supplying module and the power-receiving module.

Another aspect of the present invention is the wireless power transmission apparatus, adapted so that coupling coefficients between coils of the power-supplying module and the power-receiving module are adjusted so that the transmission characteristic with respect to the power-source frequency of the power in the power-supplying resonator and the power-receiving resonator has two peak bands, and that the input impedance of the wireless power transmission apparatus including the device to be powered has two peak bands.

The above structure allows a setting that achieve two peak bands in the transmission characteristic with respect to the power-source frequency of the power in the power-supplying resonator and the power-receiving resonator and two peak bands in the input impedance of the wireless power transmission apparatus with respect to the power-source frequency of the power, by varying the values of the coupling coefficients between coils constituting the power-supplying module and the power-receiving module.

Another aspect of the present invention is the wireless power transmission apparatus, adapted so that the values of the coupling coefficients between coils of the power-supplying module and the power-receiving module are adjusted by varying distances between the coils.

The above structure enables adjustment of the coupling coefficients between coils of the power-supplying module and the power-receiving module, by varying the distances between coils. As such, the adjustment is possible with a simple designing of varying the distances between coils.

Another aspect of the present invention to achieve the above object is the wireless power transmission apparatus adapted so that the power-source frequency of the power supplied to the power-supplying module is set to a frequency band corresponding to a peak band, out of the two peak bands of the transmission characteristic, on the high frequency side.

In the above structure, the power-source frequency of the power supplied to the power-supplying module is set to a frequency band corresponding to a peak band, out of the two peak bands of the transmission characteristic, on the high frequency side. This enables formation of a magnetic field space between the power-supplying resonator and the power-receiving resonator, the magnetic field space having a magnetic field strength smaller than the strength of the nearby magnetic field.

Another aspect of the present invention to achieve the above object is the wireless power transmission apparatus adapted so that the power-source frequency of the power supplied to the power-supplying module is set to a frequency band corresponding to a peak band, out of the two peak bands of the transmission characteristic, on the low frequency side.

In the above structure, the power-source frequency of the power supplied to the power-supplying module is set to a frequency band corresponding to a peak band, out of the two peak bands of the transmission characteristic, on the low frequency side. This enables formation of a magnetic field space outside the power-supplying resonator and the power-receiving resonator, the magnetic field space having a magnetic field strength smaller than the strength of the nearby magnetic field.

Another aspect of the present invention to achieve the above objects is a manufacturing method of a wireless power transmission apparatus configured to supply power from a power-supplying module to a power-receiving module by varying a magnetic field, the power-supplying module comprising at least a power-supplying resonator, the power-receiving module comprising at least a power-receiving resonator, the power-receiving module connected to a device to be powered with variable load, the method comprising:

carrying out setting so that the transmission characteristic with respect to the power-source frequency of the power, in the power-supplying resonator and the power-receiving resonator, has two peak bands; and
carrying out setting so that, when the load in the device to be powered is at its maximum value within its load fluctuation range, the input impedance of the wireless power transmission apparatus including the device to be powered, with respect to the power-source frequency of the power has at least two peak bands.

With a wireless power transmission apparatus manufactured through the above method, the value of the input impedance of the entire wireless power transmission apparatus including the device to be powered is varied according to the fluctuation tendency of the load of the device to be powered, when the load of the target device is varied. For example, when the load of the target device rises, it is possible to raise the value of input impedance of the entire wireless power transmission apparatus including the target device. Thus, when the load of the target device rises, the input current to the wireless power transmission apparatus including the target device is reduced. This enables reduction of the power consumption when the load of the target device is increased.

Advantageous Effects

There is provided a wireless power transmission apparatus capable of varying the input impedance of the entire wireless power transmission apparatus including a target device, when the load of the target device varies, according to a tendency of variation in the load of the target device, without an additional device. It is a further object to provide a manufacturing method for such a wireless power transmission apparatus.

Brief Description of Drawings

[FIG. 1] FIG.1 is an explanatory diagram of a charger and an RF headset mounted in the wireless power transmission apparatus related to one embodiment.
[FIG. 2] FIG. 2 is a schematic explanatory diagram of a wireless power transmission apparatus.
[FIG. 3] FIG. 3 is an explanatory diagram of an equivalent circuit of the wireless power transmission apparatus.
[FIG. 4] FIG. 4 is an explanatory diagram for a case where the transmission characteristic "S21" between resonators has two peaks.
[FIG. 5] FIG. 5 is an explanatory diagram of a wireless power transmission apparatus connected to a network analyzer.
[FIG. 6] FIG. 6 is a magnetic field vector diagram in the antiphase resonance mode.
[FIG. 7] FIG. 7 is a magnetic field vector diagram in the inphase resonance mode.
[FIG. 8A] FIG. 8A is a graph indicating charging characteristic of a lithium ion secondary battery.
[FIG. 8B] FIG. 8B is a graph indicating charging characteristic of a lithium ion secondary battery.
[FIG. 9] FIG. 9 is a graph showing a relationship between an inter-coil distance (distance between coils) and a coupling coefficient, in the wireless power transmission.
[FIG. 10A] FIG. 10A shows a measurement result related to Example 1, and is a graph of an S21 measurement result.
[FIG. 10B] FIG. 10B shows a measurement result related to Example 1, and is a graph of an input impedance with respect to a power-source frequency.
[FIG. 10C] FIG. 10C shows a measurement result related to Example 1, and is an explanatory diagram of a termination load tendency.

[FIG. 11A] FIG. 11A shows a measurement result related to Example 2, and is a graph of an S21 measurement result.

[FIG. 11B] FIG. 11B shows a measurement result related to Example 2, and is a graph of an input impedance with respect to a power-source frequency.

[FIG. 11C] FIG. 11C shows a measurement result related to Example 2, and is an explanatory diagram of a termination load tendency.

[FIG. 12A] FIG. 12A shows a measurement result related to Example 3, and is a graph of an S21 measurement result.

[FIG. 12B] FIG. 12B shows a measurement result related to Example 3, and is a graph of an input impedance with respect to a power-source frequency.

[FIG. 12C] FIG. 12C shows a measurement result related to Example 3, and is an explanatory diagram of a termination load tendency.

[FIG. 13A] FIG. 13A shows a measurement result related to Example 4, and is a graph of an S21 measurement result.

[FIG. 13B] FIG. 13B shows a measurement result related to Example 4, and is a graph of an input impedance with respect to a power-source frequency.

[FIG. 13C] FIG. 13C shows a measurement result related to Example 4, and is an explanatory diagram of a termination load tendency.

[FIG. 14A] FIG. 14A shows a measurement result related to Comparative Example, and is a graph of an S21 measurement result.

[FIG. 14B] FIG. 14B shows a measurement result related to Comparative Example, and is a graph of an input impedance with respect to a power-source frequency.

[FIG. 14C] FIG. 14C shows a measurement result related to Comparative Example, and is an explanatory diagram of a termination load tendency.

[FIG. 15] FIG. 15 is a flowchart explaining a method for designing an RF headset and a charger, including the wireless power transmission apparatus.

[Description of Embodiments]

(Embodiment)

The following describes an embodiment of a wireless power transmission apparatus and a manufacturing method for the wireless power transmission apparatus related to the present invention.

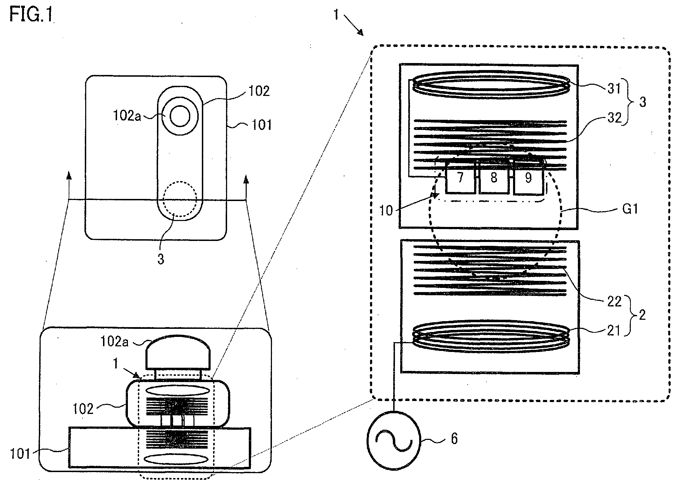

As shown in FIG. 1, the present embodiment describes a charger 101 having a power-supplying module 2 and an RF headset 102 having a power-receiving module 3 as an example of the wireless power transmission apparatus 1 essentially including a power-supplying module 2 including a power-supplying resonator 22 and a power-receiving module 3 including a power-receiving resonator 32, which apparatus is capable of forming a magnetic field space G1 (G2) whose magnetic field strength is smaller than the strength of the surrounding magnetic field. It should be noted that FIG. 1 shows the charger 101 and the RF headset 102 in the process of charging.

(Structures of Charger 101 and RF Headset 102)

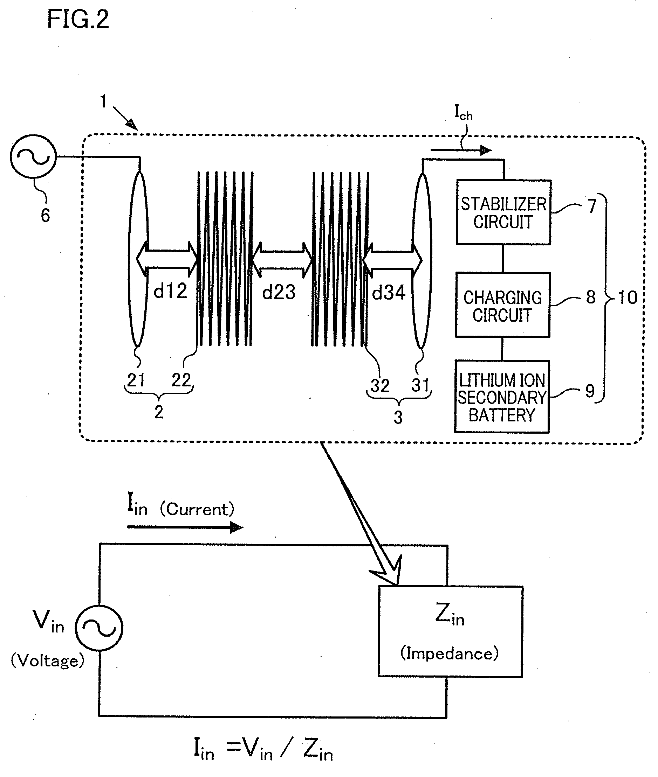

As shown in FIG. 1, a charger 101 includes a power-supplying coil 21 and a power-supplying module 2 having a power-supplying resonator 22. An RF headset 102 includes an earphone speaker unit 102a, a power-receiving coil 31, and a power-receiving module 3 having a power-receiving resonator 32. The power-supplying coil 21 of the power-supplying module 2 is connected to an AC power source 6 having an oscillation circuit with the power-source frequency of the power to be supplied to the power-supplying module 2 to a predetermined value. The power-receiving coil 31 of the power-receiving module 3 is connected to a lithium ion secondary battery 9 via a charging circuit 8 configured to prevent overcharge and a stabilizer circuit 7 configured to rectify the AC power received. The stabilizer circuit 7, the charging circuit 8, and the lithium ion secondary battery 9 are arranged so as to be positioned inner circumference side of the power-receiving resonator 32 (It should be noted that, on the drawings, the stabilizer circuit 7, the charging circuit 8, and the lithium ion secondary battery 9 are illustrated outside the power-receiving resonator 32, for the sake of convenience). On the inner circumference side of the power-receiving resonator 32 in which the stabilizer circuit 7, the charging circuit 8, and the lithium ion secondary battery 9 are arranged, a magnetic field space G1 is formed during the process of charging. This magnetic field space G1 has a magnetic field strength smaller than that of the surrounding magnetic field space, the details of which is provided later. It should be noted that, as shown in FIG. 1 and FIG. 2, the stabilizer circuit 7, the charging circuit 8, and the lithium ion secondary battery 9 of the present embodiment are a device to be powered (hereinafter, referred to as target device) 10 which is the final destination of the supplied power. The target device 10 is a generic term for the all the devices to which the supplied power is destined, which is connected to the power-receiving module 3.

Further, although illustration is omitted, the charger 101 is provided with an accommodation groove for accommodating and conforms to the shape of the RF headset 102. By accommodating the RF headset 102 to this groove, the RF headset 102 is positioned so that the power-supplying module 2 of the charger 101 and the power-receiving module 3 of the RF headset 102 face each other.

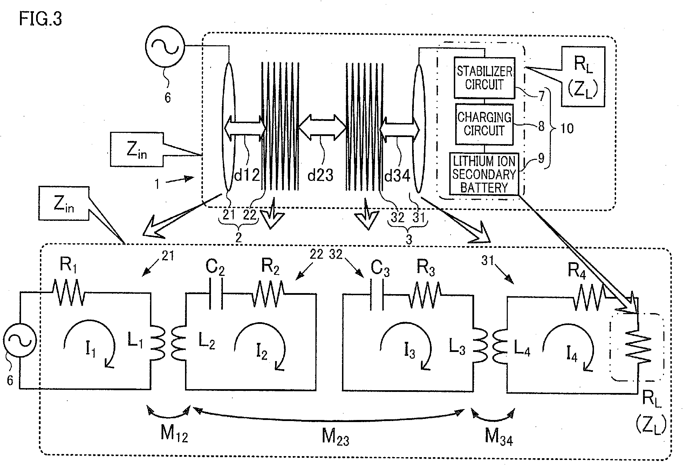

The power-supplying coil 21 plays a role of supplying the power from an AC power source 6 to the power-supplying resonator 22 by means of electromagnetic induction. As shown in FIG. 3, the power-supplying coil 21 is constituted by an RL circuit whose elements include a resistor $R_1$ and a coil $L_1$. As the coil $L_1$ is adopted a solenoid coil. The total impedance of a circuit element constituting the power-supplying coil 21 is $Z_1$. In the present embodiment, the $Z_1$ is the total impedance of the RL circuit (circuit element) constituting the power-supplying coil 21, which includes the resistor $R_1$ and the coil $L_1$. Further, the current that flows in the power-supplying coil 21 is $I_1$. It should be noted that the current $I_1$ is the same as the input current $I_{in}$ to the wireless power transmission apparatus 1. Further, the present embodiment deals with a case where the power-supplying coil 21 is an RL circuit as an example; however, the power-supplying coil 21 may be structured in the form of an RLC circuit.

The power-receiving coil 31 plays roles of receiving the power having been transmitted as a magnetic field energy from the power-supplying resonator 22 to the power-receiving resonator 32, by means of electromagnetic induction, and supplying the power received to the lithium ion secondary battery 9 via the stabilizer circuit 7 and the charging circuit 8. As shown in FIG. 3, the power-receiving coil 31, similarly to the power-supplying coil 21, is constituted by an RL circuit whose elements include a resistor $R_4$ and a coil $L_4$. As the coil $L_4$ is adopted a solenoid coil. The total impedance of a circuit element constituting the power-receiving coil 31 is $Z_4$. In the present embodiment, the $Z_4$ is the total impedance of the RL circuit (circuit element) constituting the power-receiving coil 31, which includes the resistor $R_4$ and the coil $L_4$. The total load impedance of a target device 10 (the stabilizer circuit 7, the charging circuit 8, and the lithium ion secondary battery 9) connected to the power-receiving coil 31 is $Z_L$. Further, the current that flows in the power-receiving coil 31 is $I_4$. The total load impedance of the target device 10 expressed as $Z_L$ may be replaced with $R_L$, for the sake of convenience. Further, the present embodiment deals with a case where the power-receiving coil 31 is an RL circuit as an example; however, the power-receiving coil 31 may be structured in the form of an RLC circuit.

As shown in FIG. 3, the power-supplying resonator 22 is constituted by an RLC circuit whose elements include a resistor $R_2$, a coil $L_2$, and a capacitor $C_2$. Further, as shown in FIG. 3, the power-receiving resonator 32 is constituted by an RLC circuit whose elements include a resistor $R_3$, a coil $L_3$, and a capacitor $C_3$. The power-supplying resonator 22 and the power-receiving resonator 32 each serves as a resonance circuit and plays a role of creating a magnetic field resonant state. The magnetic field resonant state (resonance phenomenon) here is a phenomenon in which two or more coils resonate with each other at a resonance frequency band. The total impedance of a circuit element constituting the power-supplying resonator 22 is $Z_2$. In the present embodiment, the $Z_2$ is the total impedance of the RLC circuit (circuit element) constituting the power-supplying resonator 22, which includes the resistor $R_2$, the coil $L_2$, and the capacitor $C_2$. The total impedance of a circuit element constituting the power-receiving resonator 32 is $Z_3$. In the present embodiment, the $Z_3$ is the total impedance of the RLC circuit (circuit element) constituting the power-receiving resonator 32, which includes the resistor $R_3$, the coil $L_3$, and the capacitor $C_3$. Further, the current that flows in the power-supplying resonator 22 is $I_2$, and the current that flows in the power-receiving resonator 32 is $I_3$.

In the RLC circuit which is the resonance circuit in each of the power-supplying resonator 22 and the power-receiving resonator 32, the resonance frequency is fo which is derived from (Formula 1) below, where the inductance is L and the capacity of capacitor is C.

[Equation 1]

$$f = \frac{1}{2\pi\sqrt{LC}} \quad \text{..... (Formula 1)}$$

Further, as the power-supplying resonator 22 and the power-receiving resonator 32 are used solenoid coils. The resonance frequency of the power-supplying resonator 22 and that of the power-receiving resonator 32 are matched with each other. The power-supplying resonator 22 and the power-receiving resonator 32 may be a spiral coil or a solenoid coil as long as it is a resonator using a coil.

In regard to the above, the distance between the power-supplying coil 21 and the power-supplying resonator 22 is denoted as d12, the distance between the power-supplying resonator 22 and the power-receiving resonator 32 is denoted as d23, and the distance between the power-receiving resonator 32 and the power-receiving coil 31 is denoted as d34 (see FIG. 2 and FIG. 3).

Further, as shown in FIG. 2, a mutual inductance between the coil $L_1$ of the power-supplying coil 21 and the coil $L_2$ of the power-supplying resonator 22 is $M_{12}$, a mutual inductance between the coil $L_2$ of the power-supplying resonator 22 and the coil $L_3$ of the power-receiving resonator 32 is $M_{23}$, and a mutual inductance between the coil $L_3$ of

the power-receiving resonator 32 and the coil $L_4$ of the power-receiving coil 31 is $M_{34}$. Further; in regard to the wireless power transmission apparatus 1, a coupling coefficient between the coil $L_1$ and the coil $L_2$ is denoted as $K_{12}$, a coupling coefficient between the coil $L_2$ and the coil $L_3$ is denoted as $K_{23}$, a coupling coefficient between the coil $L_3$ and the coil $L_4$ is denoted as $K_{34}$.

Note that FIG. 2 shows at its bottom a circuit diagram of the wireless power transmission apparatus 1 (including: the stabilizer circuit 7, the charging circuit 8, and the lithium ion secondary battery 9) having the structure as described above. In the figure, the entire wireless power transmission apparatus 1 is shown as a single input impedance $Z_{in}$. Further, the voltage applied to the wireless power transmission apparatus 1 is indicated as voltage $V_{in}$, and the current input to the wireless power transmission apparatus 1 is indicated as current $I_{in}$.

The (Formula 2) is a relational expression of the current $I_{in}$, based on the voltage $V_{in}$ and input impedance $Z_{in}$.

[Equation 2]

$$I_{in} = \frac{V_{in}}{Z_{in}} \quad \ldots\ldots \text{(Formula 2)}$$

To be more specific about the input impedance $Z_{in}$ of the wireless power transmission apparatus 1, the structure of the wireless power transmission apparatus 1 is expressed in an equivalent circuit as shown in FIG. 3. Based on the equivalent circuit in FIG. 3, the input impedance $Z_{in}$ of the wireless power transmission apparatus 1 is expressed as the (Formula 3).

[Equation 3]

$$Z_{in} = Z_1 + \cfrac{(\omega M_{12})^2}{Z_2 + \cfrac{(\omega M_{23})^2}{Z_3 + \cfrac{(\omega M_{34})^2}{Z_4 + Z_L}}}$$

$$M_{12} = k_{12}\sqrt{L_1 L_2} \qquad M_{23} = k_{23}\sqrt{L_2 L_3} \qquad M_{34} = k_{34}\sqrt{L_3 L_4}$$

$$(\text{K}_{ij} \text{ is coupling coefficient between } \text{L}_i \text{ and } \text{L}_j)$$

$$\ldots\ldots \text{(Formula 3)}$$

Further, the impedance $Z_1$, $Z_2$, $Z_3$, $Z_4$, and $Z_L$ of the power-supplying coil 21, the power-supplying resonator 22, the power-receiving resonator 32, and the power-receiving coil 31 in the wireless power transmission apparatus 1 of the present embodiment are expressed as the (Formula 4).

[Equation 4]

$$Z_1 = R_1 + j\omega L_1$$

$$Z_2 = R_2 + j\left(\omega L_2 - \frac{1}{\omega C_2}\right)$$

$$Z_3 = R_3 + j\left(\omega L_3 - \frac{1}{\omega C_3}\right)$$

$$Z_4 = R_4 + j\omega L_4$$

$$Z_L = R_L$$

..... (Formula 4)

Introducing the (Formula 4) into the (Formula 3) makes the (Formula 5).
[Equation 5]

$$Z_{in} = R_1 + j\omega L_1 + \cfrac{(\omega M_{12})^2}{R_2 + j\left(\omega L_2 - \cfrac{1}{\omega C_2}\right) + \cfrac{(\omega M_{23})^2}{R_3 + j\left(\omega L_3 - \cfrac{1}{\omega C_3}\right) + \cfrac{(\omega M_{34})^2}{R_4 + j\omega L_4 + R_L}}}$$

..... (Formula 5)

It should be noted that the resistance value, inductance, capacity of capacitor, and the coupling coefficients $K_{12}$, $K_{23}$, $K_{34}$ in the $R_1$ and $L_1$ of the RL circuit of the power-supplying coil 21, the $R_2$, $L_2$, and $C_2$ of the RLC circuit of the power-supplying resonator 22, the $R_3$, $L_3$, and $C_3$ of the RLC circuit of the power-receiving resonator 32, the $R_4$ and $L_4$ of the RL circuit of the power-receiving coil 31 are set as parameters variable at the stage of designing and manufacturing.
With the wireless power transmission apparatus 1, when the resonance frequency of the power-supplying resonator 22 and the resonance frequency of the power-receiving resonator 32 match with each other, a magnetic field resonant state is created between the power-supplying resonator 22 and the power-receiving resonator 32. When a magnetic field resonant state is created between the power-supplying resonator 22 and the power-receiving resonator 32 by having these resonators resonating with each other, power is transmitted from the power-supplying resonator 22 to the power-receiving resonator 32 as magnetic field energy. Then, the power received by the power-receiving resonator 32 is supplied to the lithium ion secondary battery 9 thus charging the same via the power-receiving coil 31, the stabilizer circuit 7, and the charging circuit 8.

(Formation of Magnetic Field Space)

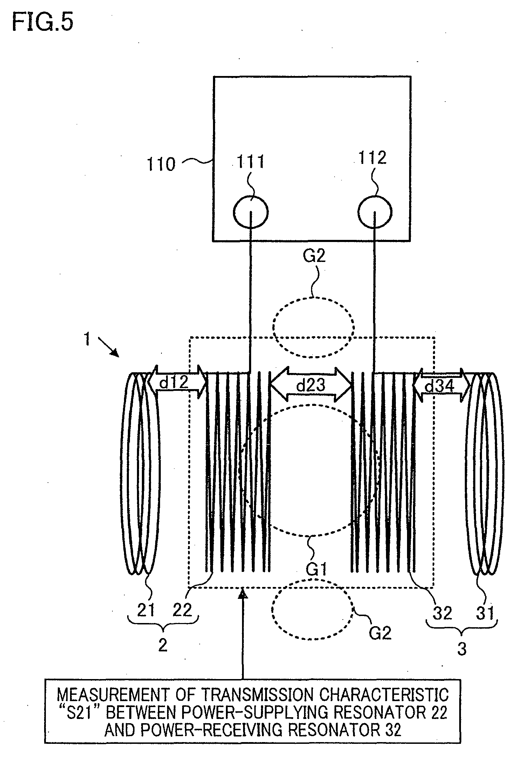

In the wireless power transmission apparatus 1 of the present embodiment, a magnetic field space G1 or G2 with weakened magnetic field strengths is formed to restrain the strength of the magnetic field occurring inside and around the power-supplying module 2 and the power-receiving module 3. Specifically as shown in FIG. 1 to FIG. 5, when the power is supplied from the power-supplying resonator 22 of the power-supplying module 2 to the power-receiving resonator 32 of the power-receiving module 3 by utilizing a resonance phenomenon, a magnetic field space G1 or G2 is formed nearby the power-supplying resonator 22 and the power-receiving resonator 32, the magnetic field space G1 or G2 having a smaller magnetic field strength than the strength of the surrounding magnetic field.
To form the magnetic field space G1 or G2, setting is carried out so that a graph showing the transmission characteristic "S21" with respect to the power-source frequency in the power-supplying resonator 22 and the power-receiving resonator 32 exhibits two peak bands, and the power-source frequency of the power to be supplied to the power-supplying module is set to a power-source frequency corresponding to any of the two peak bands. As shown in FIG. 1 to FIG. 5, in the present embodiment, the magnetic field space G1 is formed between the power-supplying resonator 22 and the power-receiving resonator 32 by setting the power-source frequency to a frequency corresponding to a peak band out of the two peak bands, on the high frequency side. It should be noted that, to form the magnetic field space G2 outside the power-supplying resonator 22 and the power-receiving resonator 32 (see FIG. 5), the power-source frequency is set to a frequency corresponding to a peak band out of the two peak bands, on the low frequency side.

The transmission characteristic "S21" is signals measured by a network analyzer 110 (e.g. E5061B produced by Agilent Technologies, Inc. and the like; see FIG. 5) connected to the wireless power transmission apparatus 1 (the power-supplying module 2 and the power-receiving module 3), and is indicated in decibel. The greater the value, it means the power transmission efficiency is high. Further, the power transmission efficiency means a ratio of the power output to the input terminal 112 for the power supplied from the output terminal 111 to the power-supplying module 2, while the wireless power transmission apparatus 1 is connected to the network analyzer 110.

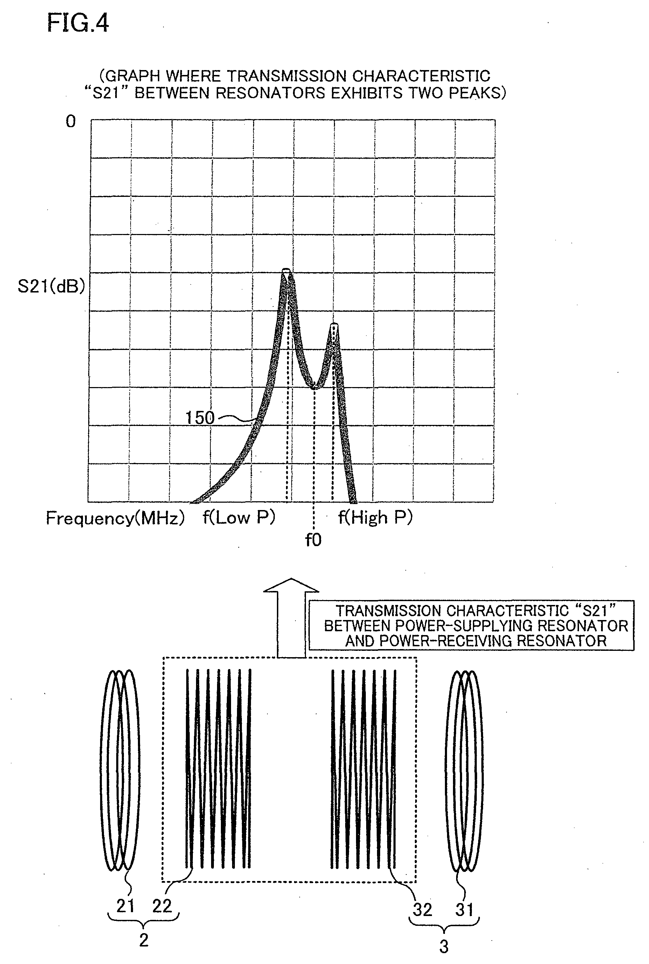

Specifically, as shown in FIG. 5, the transmission characteristic "S21" with respect to the power-source frequency, in the power-supplying resonator 22 and the power-receiving resonator 32 is analyzed by using the network analyzer 110, with various power-source frequencies to be supplied to the power-supplying resonator 22. In this regard, as shown in the graph of FIG. 4, the horizontal axis indicates the power-source frequencies of the AC power output from the output terminal 111, and the vertical axis indicates the transmission characteristic "S21 ". In measurement of the transmission characteristic "S21" in the power-supplying resonator 22 and the power-receiving resonator 32, if the coupling between the power-supplying coil 21 and the power-supplying resonator 22 is strong, the coupling state of the power-supplying resonator 22 and the power-receiving resonator 32 is affected. Due to this, accurate measurement of the transmission characteristic "S21" in the power-supplying resonator 22 and the power-receiving resonator 32 is difficult. For this reason, a distance d12 between the power-supplying coil 21 and the power-supplying resonator 22 needs to be kept at a distance such that the power-supplying resonator 22 is sufficiently excited, a magnetic field by the power-supplying resonator 22 is generated, and coupling of the power-supplying coil 21 and the power-supplying resonator 22 with each other is prevented as much as possible. Further, for the similar reason, a distance d34 between the power-receiving resonator 32 and the power-receiving coil 31 needs to be kept at a distance such that the power-receiving resonator 32 is sufficiently excited, a magnetic field by the power-receiving resonator 32 is generated, and coupling of the power-receiving resonator 32 and the power-receiving coil 31 with each other is prevented as much as possible. Then, as shown in FIG. 4, setting is carried out so that an analysis-result waveform of the transmission characteristic "S21" in the power-supplying resonator 22 and the power-receiving resonator 32 has two peak bands which are a peak band (f(Low P)) occurring on the low frequency side and a peak band (f(High P)) occurring on the high frequency side (see solid line 150).

To cause the analysis-result waveform of the transmission characteristic "S21" in the power-supplying resonator 22 and the power-receiving resonator 32 to have its peak split into two peak bands, one on the low frequency side and the other on the high frequency side, as hereinabove described, the distance d23 between the power-supplying resonator 22 and the power-receiving resonator 32 is adjusted, and/or variable parameters of the power-supplying resonator 22 and the power-receiving resonator 32 are adjusted. Examples of such parameters include resistance, inductance, and capacities of the $R_2$, $L_2$, $C_2$ of the RLC circuit of the power-supplying resonator 22 and $R_3$, $L_3$, $C_3$ of the RLC circuit of the power-receiving resonator 32, and a coupling coefficient $K_{23}$.

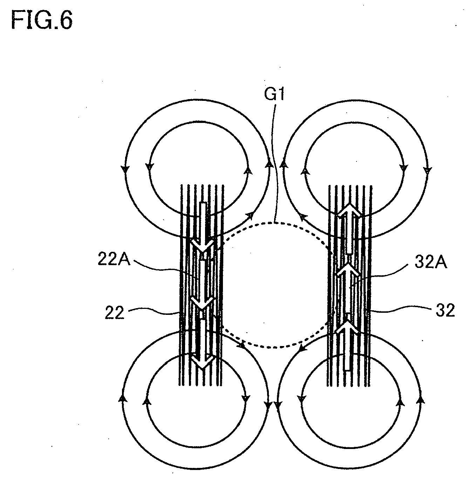

When the analysis-result waveform of the transmission characteristic "S21" of the power-supplying resonator 22 and the power-receiving resonator 32 has two peak bands, and when the power-source frequency of AC power to be supplied is set on the peak band (f(High P)) on the high frequency side, the power-supplying resonator 22 and the power-receiving resonator 32 resonate with each other in antiphase, and the direction (22A) of the current in the power-supplying resonator 22 and the direction (32A) of the current in the power-receiving resonator 32 are opposite to each other, as shown in FIG. 6. As a result, as the magnetic field vector diagram in FIG. 6 shows, because the magnetic field generated on the inner circumference side of the power-supplying resonator 22 and the magnetic field generated on the inner circumference side of the power-receiving resonator 32 cancel each other out, the magnetic field space G1 having a lower magnetic field strength than the magnetic field strengths in positions not on the inner circumference sides of the power-supplying resonator 22 and the power-receiving resonator 32 (e.g., the magnetic field strengths on the outer circumference sides of the power-supplying resonator 22 and the power-receiving resonator 32) is formed on the inner circumference sides of the power-supplying resonator 22 and the power-receiving resonator 32, as the effect of the magnetic fields is lowered. Note that the resonance state in which the current in the power-supplying resonator 22 and the current in the power-receiving resonator 32 flow in directions opposite to each other is referred to as antiphase resonance mode.

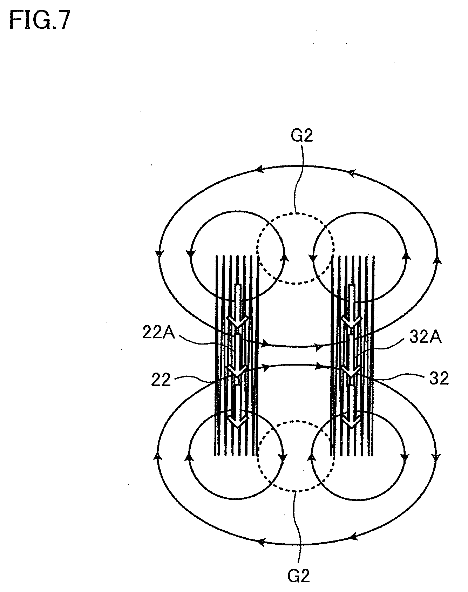

On the other hand, when the analysis-result waveform of the transmission characteristic "S21" of the power-supplying resonator 22 and the power-receiving resonator 32 has two peak bands, and when the power-source frequency of AC power to be supplied is set on the peak band (f(Low P)) on the low frequency side, the power-supplying resonator 22 and the power-receiving resonator 32 resonate with each other in inphase, and the direction (22A) of the current in the power-supplying resonator 22 and the direction (32A) of the current in the power-receiving resonator 32 are the same, as shown in FIG. 7. As a result, as the magnetic field vector diagram in FIG. 7 shows, because the magnetic field generated on the outer circumference side of the power-supplying resonator 22 and the magnetic field generated on the outer circumference side of the power-receiving resonator 32 cancel each other out, the magnetic field space G2 having a lower magnetic field strength than the magnetic field strengths in positions not on the outer circumference sides of the power-supplying resonator 22 and the power-receiving resonator 32 (e.g., the magnetic field strengths on the outer circumference sides of the power-supplying resonator 22 and the power-receiving resonator 32) is formed on the inner circumference sides of the power-supplying resonator 22 and the power-receiving resonator 32, as the effects of the magnetic fields is lowered. Note that the resonance state in which the current in the power-supplying resonator 22 and the current in the power-receiving resonator 32 both flow in the same direction is referred to as inphase resonance mode.

(Load Fluctuation in Wireless Power Transmission Apparatus associated with Load Fluctuation in Target Device)

With a lithium ion secondary battery as an example, the following describes effects brought about by load fluctuation in the wireless power transmission apparatus 1 associated with that in the lithium ion secondary battery.

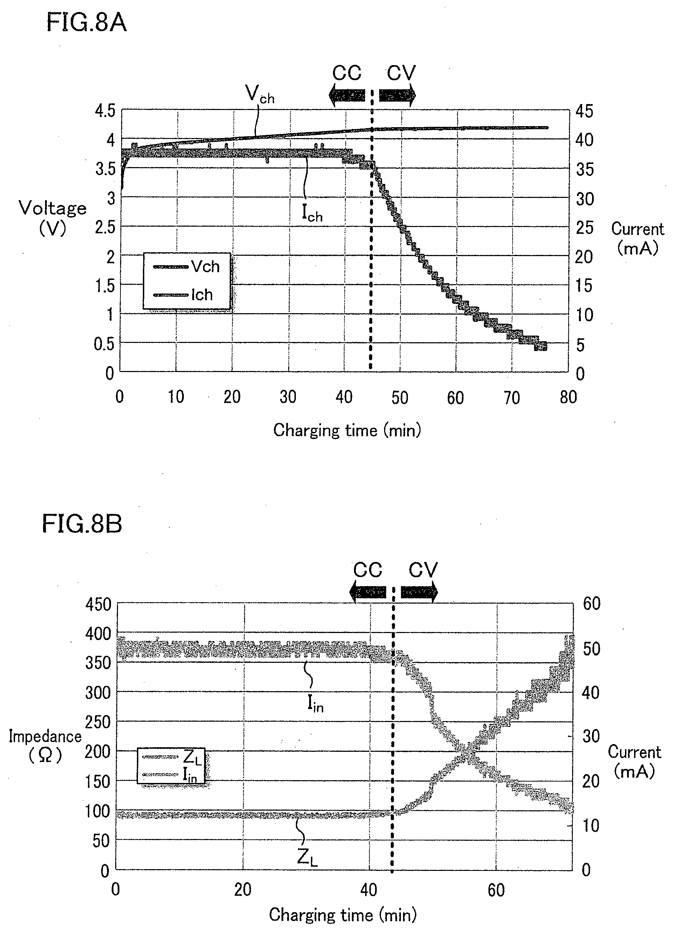

In the present embodiment, the lithium ion secondary battery 9 is used as one of the target devices 10 to which the power is supplied. To charge the lithium ion secondary battery 9, a constant current/constant voltage charging system is used in general. When charging the lithium ion secondary battery 9 by a constant current/constant voltage charging system, the lithium ion secondary battery 9 is charged by a constant current (CC: Constant Current) for a while after charging is started, as in the charging characteristic of the lithium ion secondary battery 9 shown in FIG. 8A. Then, the voltage ($V_{ch}$) to be applied rises up to a predetermined upper limit voltage (4.2 V in the present embodiment), while the charging by the constant current. When the voltage ($V_{ch}$) reaches the upper limit voltage, charging by a constant voltage is performed (CV: Constant Voltage), while the upper limit voltage is maintained. After the charging by the constant voltage, the current value ($I_{ch}$) attenuates, and the charging is completed when the value of the current reaches a predetermined value, or when a predetermined time is elapsed.

Suppose the lithium ion secondary battery 9 is charged by means of the constant current/constant voltage charging system using the wireless power transmission apparatus 1. In this case, when there is transition from constant current charging (CC) to constant voltage charging (CV), the value of the load impedance $Z_L$ rises during the constant voltage (CV) charging, and the current value ($I_{in}$) supplied to the stabilizer circuit 7, the charging circuit 8, and the lithium ion secondary battery 9, which constitute the target device 10 is attenuated as is indicated by the load fluctuation characteristics shown in FIG. 8B of the load impedance $Z_L$ related to the stabilizer circuit 7, the charging circuit 8, and the lithium ion secondary battery 9. In short, there will be a rise in the value of the load impedance $Z_1$ of the entire target device 10 (stabilizer circuit 7, charging circuit 8, lithium ion secondary battery 9) of the present embodiment (load fluctuation).

Then, with the rise in the value of the load impedance $Z_L$ of the target device, the input impedance $Z_{in}$ of the entire wireless power transmission apparatus 1 including the target device 10 is fluctuated. If the input impedance $Z_{in}$ of the entire wireless power transmission apparatus 1 including the target device 10 drops, with a rise in the value of the load impedance $Z_L$ of the target device 10, the input current to the wireless power transmission apparatus 1 including the target device 10 will increase, thus increasing the power consumption in the wireless power transmission apparatus 1 including the target device 10, with the rise in the load impedance of the target device 10, under a certain voltage.

To the contrary, if the input impedance $Z_{in}$ of the entire wireless power transmission apparatus 1 including the target device 10 is raised, with a rise in the value of the load impedance $Z_L$ of the target device 10, the input current to the wireless power transmission apparatus 1 including the target device 10 is reduced, thus reducing the power consumption in the wireless power transmission apparatus 1 including the target device 10, with the rise in the load impedance of the target device 10, under a certain voltage. For example, it is possible to reduce the power consumed at the time of charging (particularly after the transition to the constant voltage charging).

That is, the power consumption in the wireless power transmission apparatus 1 including the target device 10 is reduced according to the load fluctuation on the target device 10, if it is possible to raise the input impedance $Z_{in}$ of the entire wireless power transmission apparatus 1 including the target device 10, with a rise in the value of the load impedance $Z_L$ of the target device 10. For example, if the target device 10 includes a lithium ion secondary battery 9, the amount of power consumed at the time of charging the lithium ion secondary battery 9 is reduced. Further, if the target device 10 is a drive device which operates while directly consuming power (e.g., a device operated by power supplied directly, without a use of a secondary battery and the like), the power consumption of the drive device is reduced with a rise in the load of the drive device.

In the present embodiment, to fluctuate the input impedance $Z_{in}$ of the entire wireless power transmission apparatus 1 including the target device 10 with the rise in the value of the load impedance $Z_L$ of the target device 10, the power-source frequency of power to be supplied to the power-supplying module 2 is set to a power-source frequency band corresponding to any of the two peak bands of the transmission characteristic "S21" (set to an antiphase resonance mode or inphase resonance mode) so that the transmission characteristic "S21" with respect to power-source frequency of power, in the power-supplying resonator 22 and the power-receiving resonator 32, has two peak bands; setting is carried out so that, when the load in the target device 10 is at its maximum value within its load fluctuation range (e.g., where the load fluctuates within a range of 50Ω to 200Ω, the maximum value within the range of load fluctuation is 200Ω), the input impedance $Z_{in}$ of the entire wireless power transmission apparatus 1 including the target device 10, with respect to the power-source frequency of the power has at least two peak bands.

Further, in order to carry out setting so that, when the load in the target device 10 is at its maximum value within its load fluctuation range, the input impedance $Z_{in}$ of the wireless power transmission apparatus 1 including the target device 10, with respect to the power-source frequency of the power has at least two peak bands, element values of a plurality of circuit elements of the power-supplying module 2 and the power-receiving module 3 are used as parameters and varied.

Specifically, the resistance value, inductance, capacity of capacitor, and the coupling coefficients $K_{12}$; $K_{23}$, $K_{34}$ in the $R_1$ and $L_1$ of the RL circuit of the power-supplying coil 21, the $R_2$, $L_2$, and $C_2$ of the RLC circuit of the power-supplying resonator 22, the $R_3$, $L_3$, and $C_3$ of the RLC circuit of the power-receiving resonator 32, the $R_4$ and $L_4$ of the RL circuit of the power-receiving coil 31 are set as parameters variable at the stage of designing and manufacturing. It should be noted that when an RLC circuit is adopted as the power-supplying coil 21 and the power-receiving coil 31, the capacity of the capacitor in each RLC circuit also serves as a parameter variable at the stage of designing and manufacturing.

It should be further noted that these parameters are parameters for setting so that an analyzed waveform of the transmission characteristic "S21" in the power-supplying resonator 22 and the power-receiving resonator 32 has two separate peak bands; one on the low frequency side and the other on the high frequency side.

The values of the coupling coefficients $k_{12}$, $k_{23}$, and $k_{34}$ between coils of the power-receiving module are adjustable by, for example, the following methods. Namely, these methods include: varying the distance d12 between the power-supplying coil 21 and the power-supplying resonator 22, the distance d23 between the power-supplying resonator 22 and the power-receiving resonator 32, and the distance d34 between the power-receiving resonator 32 and the power-receiving coil 31; changing the coil diameters of the power-supplying coil 21, the power-supplying resonator 22, the power-receiving resonator 32, and the power-receiving coil 31; disposing the power-supplying resonator 22 and the power-receiving resonator 32 so their axes do not match with each other; giving an angle to the coil surfaces of the power-supplying resonator 22 and the power-receiving resonator 32; varying the property of each element (resistor, capacitor, coil) of the power-supplying coil 21, the power-supplying resonator 22, the power-receiving resonator 32, and the power-receiving coil 31; and varying the drive frequency of the AC power supplied to the power-supplying module 2.

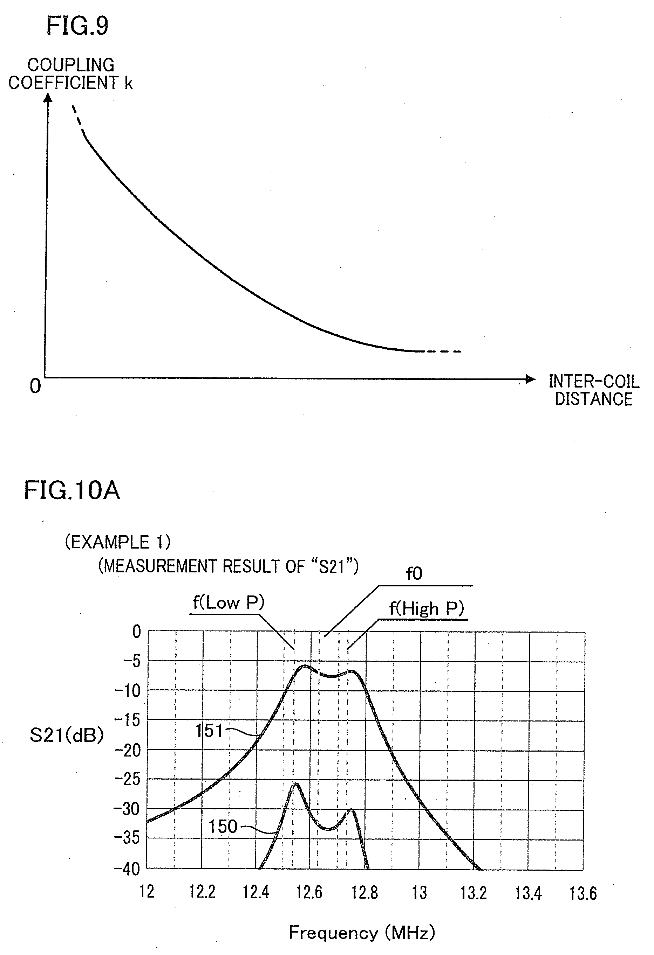

In wireless power transmission, the relation between a coupling coefficient k and a distance between a coil and another coil is typically such that the value of the coupling coefficient k increases with a decrease in (shortening of) the distance between the coil and the other coil, as shown in FIG. 9. In the wireless power transmission apparatus 1 of the present embodiment for instance, the coupling coefficient $k_{12}$ between the power-receiving coil 21 (coil $L_1$) and the power-supplying resonator 22 (coil $L_2$), the coupling coefficient $k_{23}$ between the power-supplying resonator 22 (coil $L_2$) and the power-receiving resonator 32 (coil $L_3$), and the coupling coefficient $K_{34}$ between the power-receiving resonator 32 (coil $L_3$) and the power-receiving coil 31 (coil $L_4$) are increased by reducing a distance d12 between the power-supplying coil 21 and the power-supplying resonator 22, a distance d23 between the power-supplying resonator 22 and the power-receiving resonator 32, and a distance d34 between the power-receiving resonator 32 and the power-receiving coil 31. To the contrary, the coupling coefficient $k_{12}$ between the power-receiving coil 21 (coil $L_1$) and the power-supplying resonator 22 (coil $L_2$), the coupling coefficient $k_{23}$ between the power-supplying resonator 22 (coil $L_2$) and the power-receiving resonator 32 (coil $L_3$), and the coupling coefficient $K_{34}$ between the power-receiving resonator 32 (coil $L_3$) and the power-receiving coil 31 (coil $L_4$) are lowered by extending a distance d12 between the power-supplying coil 21 and the power-supplying resonator 22, a distance d23 between the power-supplying resonator 22 and the power-receiving resonator 32, and a distance d34 between the power-receiving resonator 32 and the power-receiving coil 31.

:

(Examples and Comparative Example)

The following describes, with reference to Examples 1 to 4 and Comparative Example with different conditions, what value the input impedance $Z_{in}$ of the entire wireless power transmission apparatus 1 including the target device 10, with respect to the power-source frequency of the power, when the coupling coefficients $k_{12}$ and $k_{34}$ are varied by varying the distance d12 between the power-supplying coil 21 and the power-supplying resonator 22 and the distance d34 between the power-receiving resonator 32 and the power-receiving coil 31.

In Examples 1 to 4 and comparative example, the wireless power transmission apparatus 1 was connected to an impedance analyzer (the present embodiment adopts E5061B produced by Agilent Technologies, Inc.), and input impedance $Z_{in}$ including the target device 10 with respect to the power-source frequency was measured. It should be noted that the measurements were conducted with a variable resistor ($R_L$) substituting for the target device 10 (stabilizer circuit 7, the charging circuit 8, and the lithium ion secondary battery 9), in Examples 1 to 4 and Comparative Example. The value of the variable resistor ($R_L$) was switched among three values that are 50Ω, 100Ω, and 200Ω to simulate fluctuation in the load impedance $Z_L$ of the target device 10.

In the wireless power transmission apparatus 1 used in Example 1 to 4 and Comparative Example, the power-supplying coil 21 is constituted by an RL circuit including a resistor $R_1$ and a coil $L_1$. The coil $L_1$ is a single-turn coil of a 1-mmφ copper wire material (coated by an insulation film) with its coil diameter set to 100 mmφ (non-resonating). The power-receiving coil 31 is constituted by an RL circuit including a resistor $R_4$ and a coil $L_4$. The coil $L_4$ is a single-turn coil of a 1-mmφ copper wire material (coated by an insulation film) with its coil diameter set to 100mmφ mmφ (non-resonating), as in the case of power-supplying coil 21. Further, the power-supplying resonator 22 is constituted by an RLC circuit including a resistor $R_2$, a coil $L_2$, and a capacitor $C_2$. The coil $L_2$ adopts a 2-turn solenoid coil of 100 mmφ in its coil diameter, and is formed by a 1-mmφ copper wire material (coated by an insulation film) of 100 mmφ in its wire diameter. Further, the power-receiving resonator 32 is constituted by an RLC circuit including a resistor $R_3$, a coil $L_3$, and a capacitor $C_3$. The coil $L_2$ adopts a 2-turn solenoid coil of 100 mmφ in its coil diameter, and is formed by a 1-mmφ copper wire material (coated by an insulation film) of 100 mmφ in its wire diameter. The resonance frequency of the power-supplying resonator 22 and the power-receiving resonator 32 is 12.63 MHz. Further, the distance d23 between the power-supplying resonator 22 and the power-receiving resonator 32 was set to 120 mm, and the setting is carried out so that the transmission characteristic "S21" with respect to the power-source frequency of the power, in the power-supplying resonator 22 and the power-receiving resonator 32 has two peak bands which are a peak band (f(Low P)) occurring on the low frequency side and a peak band (f(High P)) occurring on the high frequency side (see solid lines 150 in FIG. 10A, FIG. 11A, FIG. 12A, FIG. 13A, and FIG. 14A). The distance d12 between the power-supplying coil 21 and the power-supplying resonator 22 and the distance d34 between the power-receiving resonator 32 and the power-receiving coil 31 are adjusted according to the measurement conditions.

(Example 1)

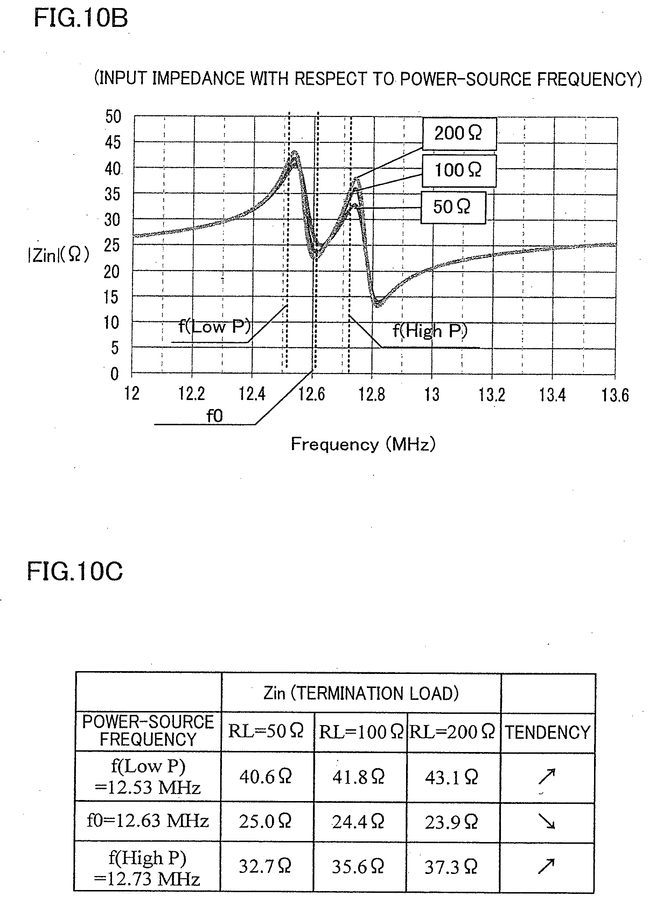

In Example 1, the distance d12 between the power-supplying coil 21 and the power-supplying resonator 22 was set to 40 mm, and the distance d34 between the power-receiving resonator 32 and the power-receiving coil 31 was set to 40 mm. The value of the variable resistor ($R_L$) was switched among three values; 50Ω, 100Ω, and 200Ω. With these conditions, the value of the input impedance $Z_{in}$ of the wireless power transmission apparatus 1 including the variable resistor (corresponding to the target device 10), with respect to the power-source frequency of the power (see FIG. 10B). The table in FIG. 10C collectively shows: measurement values in cases of setting the power-source frequency of AC power supplied to the power-supplying module 2 in the peak band (f(Low P)) on the low frequency side (inphase resonance mode: 12.53 MHz); measurement values in cases of setting the power-source frequency to the resonance frequency f0 (resonance frequency 12.63 MHz); and measurement values in cases of setting the power-source frequency in the peak band (f(High P)) on the high frequency side (antiphase resonance mode: 12.73 MHz). It should be noted that Example 1 conducted measurement of the transmission characteristic "S21" with respect to the power-source frequency of the power, in the power-supplying resonator 22 and the power-receiving resonator 32 (solid line 150), as well as the transmission characteristic "S21" in the power-supplying coil 21, the power-supplying resonator 22, the power-receiving resonator 32, and the power-receiving coil 31 (solid line 151), as shown in FIG. 10A. The measurement results are shown in FIG. 10A.

As shown in FIG. 10B, the power-source frequency was set to the resonance frequency f0. When the $R_L$ = 50Ω, the input impedance $Z_{in}$ = 25.0Ω. When the $R_L$ = 100Ω, the input impedance $Z_{in}$ = 24.4Ω. When the $R_L$ = 200Ω, the input impedance $Z_{in}$ = 23.9Ω. From these results, it is understood that the input impedance $Z_{in}$ of the entire wireless power transmission apparatus 1 drops with an increase in the load $R_L$. Therefore, when the power-source frequency is set to the resonance frequency f0, the input current to the wireless power transmission apparatus 1 including the target device 10 increases with an increase in the load $R_L$, thus increasing the power consumption in the wireless power transmission apparatus 1 including the target device 10.

Then, the power-source frequency was set in the peak band on the low frequency side (f(Low P)). When the $R_L$ = 50Ω, the input impedance $Z_{in}$ = 40.6Ω. When the $R_L$ = 100Ω, the input impedance $Z_{in}$ = 41.8Ω. When the $R_L$ = 200Ω, the input impedance $Z_{in}$ = 43.1Ω. From these results, it is understood that the input impedance $Z_{in}$ of the entire wireless power transmission apparatus 1 rises with an increase in the load $R_L$. Therefore, when the power-source frequency is set on the low frequency side (f(Low P)), the input current to the wireless power transmission apparatus 1 including the target device 10 is reduced with an increase in the load $R_L$, thus reducing the power consumption in the wireless power transmission apparatus 1 including the target device 10.

Further, the power-source frequency was set in the peak band on the High frequency side (f(High P)). When the $R_L$ = 50Ω, the input impedance $Z_{in}$ = 32.7Ω. When the $R_L$ = 100Ω, the input impedance $Z_{in}$ = 35.6Ω. When the $R_L$ = 200Q, the input impedance $Z_{in}$ = 37.3Ω. From these results, it is understood that the input impedance $Z_{in}$ of the entire wireless power transmission apparatus 1 rises with an increase in the load $R_L$. Therefore, when the power-source frequency is set on the high frequency side (f(High P)), the input current to the wireless power transmission apparatus 1 including the target device 10 is reduced with an increase in the load $R_L$, thus reducing the power consumption in the wireless power transmission apparatus 1 including the target device 10.

In Example 1, measurement was conducted while simulating load fluctuation in the load impedance $Z_L$ within a range of 50Ω to 200Ω by switching the load of the target device 10 among three values that are 50Ω, 100Ω, and 200Ω. With the maximum value of 200Ω at the range of load fluctuation, the input impedance $Z_{in}$ of the wireless power transmission apparatus 1 including the target device 10 exhibited two peak bands (see the resulting curve of 200Ω in the graph of FIG. 10B showing the input impedance with respect to the power-source frequency). Further, in Example 1, the input impedance $Z_{in}$ of the wireless power transmission apparatus 1 including the target device 10 with respect to the power-source frequency exhibited two peak bands even with the loads of 50Ω and 100Ω, when the distance d12 between the power-supplying coil 21 and the power-supplying resonator 22 and the distance d34 between the power-receiving resonator 32 and the power-receiving coil 31 were both set to 40 mm (see FIG. 10B).

(Example 2)

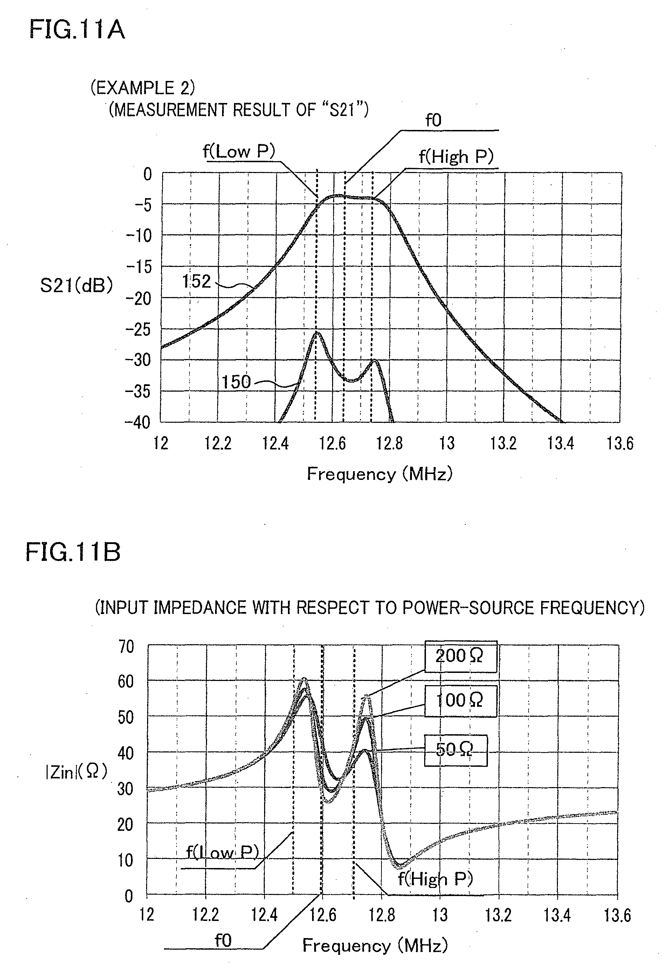

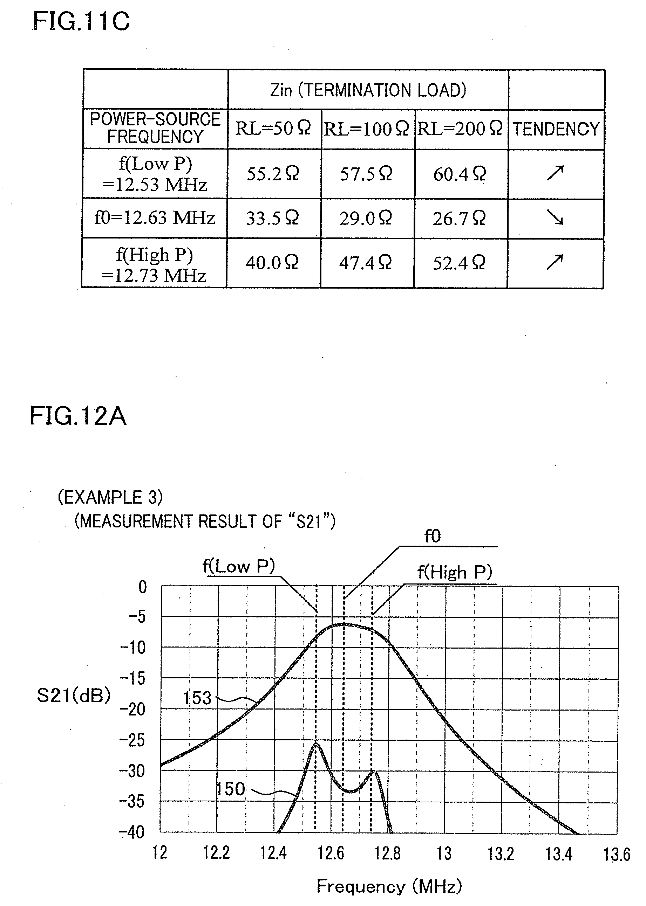

In Example 2, the distance d12 between the power-supplying coil 21 and the power-supplying resonator 22 was set to 30 mm, and the distance d34 between the power-receiving resonator 32 and the power-receiving coil 31 was set to 30 mm. The value of the variable resistor ($R_L$) was switched among three values; 50Ω, 100Ω, and 200Ω. With these conditions, the value of the input impedance $Z_{in}$ of the wireless power transmission apparatus 1 including the variable resistor (corresponding to the target device 10), with respect to the power-source frequency of the power (see FIG. 11 B). The table in FIG. 11C collectively shows: measurement values in cases of setting the power-source frequency of AC power supplied to the power-supplying module 2 in the peak band (f(Low P)) on the low frequency side (inphase resonance mode: 12.53 MHz); measurement values in cases of setting the power-source frequency to the resonance frequency f0 (resonance frequency 12.63 MHz); and measurement values in cases of setting the power-source frequency in the peak band (f(High P)) on the high frequency side (antiphase resonance mode: 12.73 MHz). It should be noted that Example 2 conducted measurement of the transmission characteristic "S21" with respect to the power-source frequency of the power, in the power-supplying resonator 22 and the power-receiving resonator 32 (solid line 150), as well as the transmission characteristic "S21" in the power-supplying coil 21, the power-supplying resonator 22, the power-receiving resonator 32, and the power-receiving coil 31 (solid line 152), as shown in FIG. 11A. The measurement results are shown in FIG. 11A.

As shown in FIG. 11B, the power-source frequency was set to the resonance frequency f0. When the $R_L$ = 50Ω, the input impedance $Z_{in}$ = 33.5Ω. When the $R_L$ = 100Ω, the input impedance $Z_{in}$ = 29.0Ω. When the $R_L$ = 200Ω, the input impedance $Z_{in}$ = 26.7Ω. From these results, it is understood that the input impedance $Z_{in}$ of the entire wireless power transmission apparatus 1 drops with an increase in the load $R_L$. Therefore, when the power-source frequency is set to the resonance frequency f0, the input current to the wireless power transmission apparatus 1 including the target device 10 increases with an increase in the load $R_L$, thus increasing the power consumption in the wireless power transmission apparatus 1 including the target device 10.

Then, the power-source frequency was set in the peak band on the low frequency side (f(Low P)). When the $R_L$ = 50Ω, the input impedance $Z_{in}$ = 55.2Ω. When the $R_L$ = 100Ω, the input impedance $Z_{in}$ = 57.5Ω. When the $R_L$ = 200Ω, the input impedance $Z_{in}$ = 60.4Ω. From these results, it is understood that the input impedance $Z_{in}$ of the entire wireless power transmission apparatus 1 rises with an increase in the load $R_L$. Therefore, when the power-source frequency is set on the low frequency side (f(Low P)), the input current to the wireless power transmission apparatus 1 including the target device 10 is reduced with an increase in the load $R_L$, thus reducing the power consumption in the wireless power transmission apparatus 1 including the target device 10.

Further, the power-source frequency was set in the peak. band on the High frequency side (f(High P)). When the $R_L$ = 50fi, the input impedance $Z_{in}$ = 40.0Ω. When the $R_L$ = 100Ω, the input impedance $Z_{in}$ = 47.7Ω. When the $R_L$ = 200Ω, the input impedance $Z_{in}$ = 52.4Ω. From these results, it is understood that the input impedance $Z_{in}$ of the entire wireless power transmission apparatus 1 rises with an increase in the load $R_L$. Therefore, when the power-source frequency is set on the high frequency side (f(High P)), the input current to the wireless power transmission apparatus 1 including the target device 10 is reduced with an increase in the load $R_L$, thus reducing the power consumption in the wireless power transmission apparatus 1 including the target device 10.

In Example 2, measurement was conducted while simulating load fluctuation in the load impedance $Z_L$ within a range of 50Ω to 200Ω by switching the load of the target device 10 among three values that are 50Ω, 100Ω, and 200Ω. With the maximum value of 200Ω at the range of load fluctuation, the input impedance $Z_{in}$ of the wireless power transmission apparatus 1 including the target device 10 exhibited two peak bands (see the resulting curve of 200Ω in the graph of FIG. 11B showing the input impedance with respect to the power-source frequency). Further, in Example 2, the input impedance $Z_{in}$ of the wireless power transmission apparatus 1 including the target device 10 with respect to the power-source frequency exhibited two peak bands even with the loads of 50Ω and 100Ω, when the distance d12 between the power-supplying coil 21 and the power-supplying resonator 22 and the distance d34 between the power-receiving resonator 32 and the power-receiving coil 31 were both set to 30 mm (see FIG. 11B).

(Example 3)

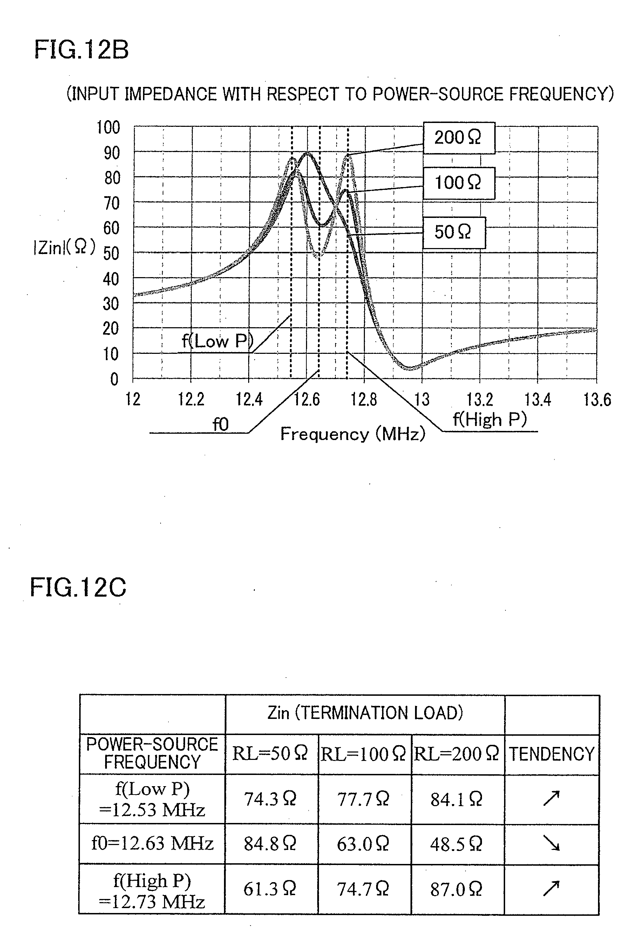

In Example 3, the distance d12 between the power-supplying coil 21 and the power-supplying resonator 22 was set to 20 mm, and the distance d34 between the power-receiving resonator 32 and the power-receiving coil 31 was set to 20 mm. The value of the variable resistor ($R_L$) was switched among three values; 50Ω, 100Ω, and 200Ω. With these conditions, the value of the input impedance $Z_{in}$ of the wireless power transmission apparatus 1 including the variable resistor (corresponding to the target device 10), with respect to the power-source frequency of the power (see FIG. 12B). The table in FIG. 12C collectively shows: measurement values in cases of setting the power-source frequency of AC power supplied to the power-supplying module 2 in the peak band (f(Low P)) on the low frequency side (inphase resonance mode: 12.53 MHz); measurement values in cases of setting the power-source frequency to the resonance frequency f0 (resonance frequency 12.63 MHz); and measurement values in cases of setting the power-source frequency in the peak band (f(High P)) on the high frequency side (antiphase resonance mode: 12.73 MHz). It should be noted that Example 3 conducted measurement of the transmission characteristic "S21" with respect to the power-source frequency of the power, in the power-supplying resonator 22 and the power-receiving resonator 32 (solid line 150), as well as the transmission characteristic "S21" in the power-supplying coil 21, the power-supplying resonator 22, the power-receiving resonator 32, and the power-receiving coil 31 (solid line 153), as shown in FIG. 12A. The measurement results are shown in FIG. 12A.

As shown in FIG. 12B, the power-source frequency was set to the resonance frequency f0. When the $R_L$ = 50Ω, the input impedance $Z_{in}$ = 84.8Ω. When the $R_L$ = 100Ω, the input impedance $Z_{in}$ = 63.0Ω. When the $R_L$ = 200Ω, the input impedance $Z_{in}$ = 48.5Ω. From these results, it is understood that the input impedance $Z_{in}$ of the entire wireless power transmission apparatus 1 drops with an increase in the load $R_L$. Therefore, when the power-source frequency is set to the resonance frequency f0, the input current to the wireless power transmission apparatus 1 including the target device 10 increases with an increase in the load $R_L$, thus increasing the power consumption in the wireless power transmission apparatus 1 including the target device 10.

Then, the power-source frequency was set in the peak band on the low frequency side (f(Low P)). When the $R_L$ = 50Ω, the input impedance $Z_{in}$ = 74.3Ω. When the $R_L$ = 100Ω, the input impedance $Z_{in}$ = 77.7Ω. When the $R_L$ = 200Ω, the input impedance $Z_{in}$ = 84.1Ω. From these results, it is understood that the input impedance $Z_{in}$ of the entire wireless power transmission apparatus 1 rises with an increase in the load $R_L$. Therefore, when the power-source frequency is set on the low frequency side (f(Low P)), the input current to the wireless power transmission apparatus 1 including the target device 10 is reduced with an increase in the load $R_L$, thus reducing the power consumption in the wireless power transmission apparatus 1 including the target device 10.

Further, the power-source frequency was set in the peak band on the High frequency side (f(High P)). When the $R_L$ 50Ω, the input impedance $Z_{in}$ = 61.3Ω. When the $R_L$ = 100Ω, the input impedance $Z_{in}$ = 74.7Ω. When the $R_L$ = 200Ω, the input impedance $Z_{in}$ = 87.0Ω. From these results, it is understood that the input impedance $Z_{in}$ of the entire wireless power transmission apparatus 1 rises with an increase in the load $R_L$. Therefore, when the power-source frequency is set on the high frequency side (f(High P)), the input current to the wireless power transmission apparatus 1 including the target device 10 is reduced with an increase in the load $R_L$, thus reducing the power consumption in the wireless power transmission apparatus 1 including the target device 10.

In Example 3, measurement was conducted while simulating load fluctuation in the load impedance $Z_L$ within a range of 50Ω to 200Ω by switching the load of the target device 10 among three values that are 50Ω, 100Ω, and 200Ω. With the maximum value of 200Ω at the range of load fluctuation, the input impedance $Z_{in}$ of the wireless power transmission apparatus 1 including the target device 10 exhibited two peak bands (see the resulting curve of 200Ω in the graph of FIG. 12B showing the input impedance with respect to the power-source frequency). Further, in Example 3, the input impedance $Z_{in}$ of the wireless power transmission apparatus 1 including the target device 10 with respect to the power-source frequency exhibited two peak bands even with the load 100Ω, when the distance d12 between the power-supplying coil 21 and the power-supplying resonator 22 and the distance d34 between the power-receiving resonator 32 and the power-receiving coil 31 were both set to 20mm (see FIG. 12B). It should be noted however, the input impedance $Z_{in}$ of the wireless power transmission apparatus 1 including the target device 10 with respect to the power-source frequency exhibited only one peak band, when the load was set to 50Ω (see FIG. 12B).

(Example 4)

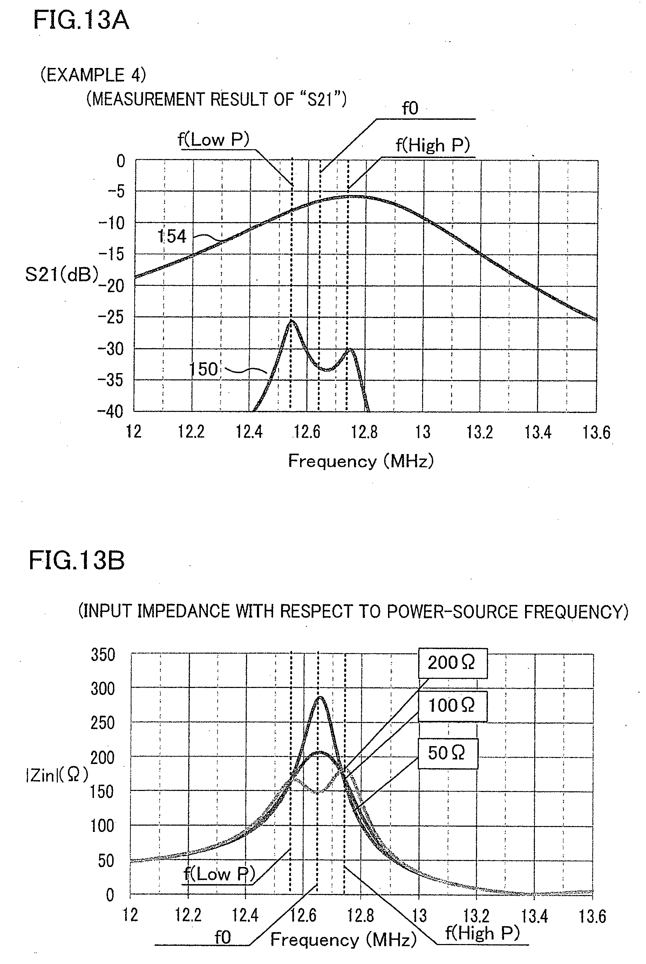

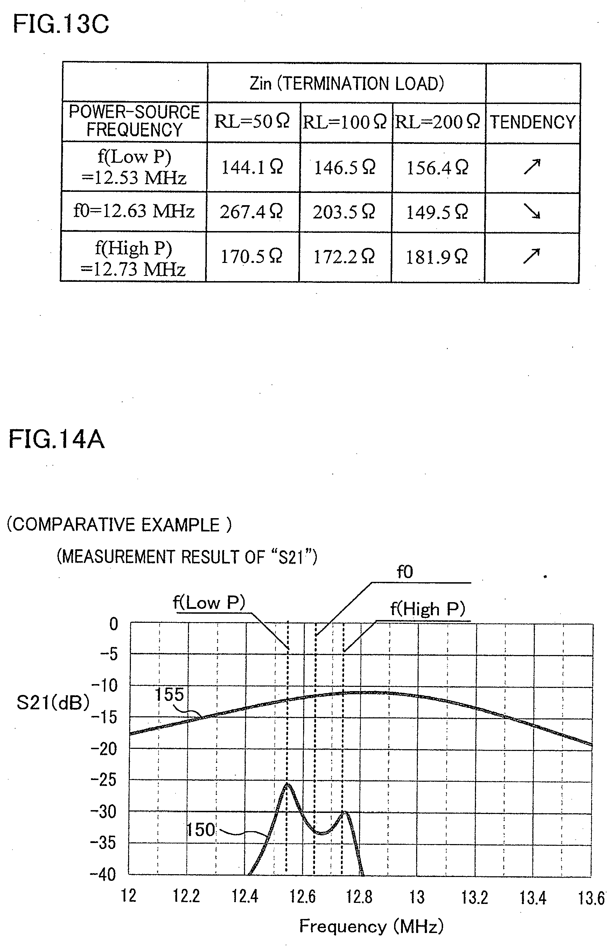

In Example 4, the distance d12 between the power-supplying coil 21 and the power-supplying resonator 22 was set to 10 mm, and the distance d34 between the power-receiving resonator 32 and the power-receiving coil 31 was set to 10 mm. The value of the variable resistor ($R_L$) was switched among three values; 50Ω, 100Ω, and 200Ω. With these conditions, the value of the input impedance $Z_{in}$ of the wireless power transmission apparatus 1 including the variable resistor (corresponding to the target device 10), with respect to the power-source frequency of the power (see FIG. 13B). The table in FIG. 13C collectively shows: measurement values in cases of setting the power-source frequency of AC power supplied to the power-supplying module 2 in the peak band (f(Low P)) on the low frequency side (inphase resonance mode: 12.53 MHz); measurement values in cases of setting the power-source frequency to the resonance frequency f0 (resonance frequency 12.63 MHz); and measurement values in cases of setting the power-source frequency in the peak band (f(High P)) on the high frequency side (antiphase resonance mode: 12.73 MHz). It should be noted that Example 4 conducted measurement of the transmission characteristic "S21" with respect to the power-source frequency of the power, in the power-supplying resonator 22 and the power-receiving resonator 32 (solid line 150), as well as the transmission characteristic "S21" in the power-supplying coil 21, the power-supplying resonator 22, the power-receiving resonator 32, and the power-receiving coil 31 (solid line 154), as shown in FIG. 13A. The measurement results are shown in FIG. 13A.

As shown in FIG. 13B, the power-source frequency was set to the resonance frequency f0. When the $R_L$ = 50Ω, the input impedance $Z_{in}$ = 267.4Ω. When the $R_L$ = 100Ω, the input impedance $Z_{in}$ = 203.5Ω. When the $R_L$ = 200Ω, the input impedance $Z_{in}$ 149.5Ω. From these results, it is understood that the input impedance $Z_{in}$ of the entire wireless power transmission apparatus 1 drops with an increase in the load $R_L$. Therefore, when the power-source frequency is set to the resonance frequency f0, the input current to the wireless power transmission apparatus 1 including the target device 10 increases with an increase in the load $R_L$, thus increasing the power consumption in the wireless power transmission apparatus 1 including the target device 10.

Then, the power-source frequency was set in the peak band on the low frequency side (f(Low P)). When the $R_L$ = 50Ω, the input impedance $Z_{in}$ = 144.1Ω. When the $R_L$ = 100Ω, the input impedance $Z_{in}$ = 146.5Ω. When the $R_L$ = 200Ω, the input impedance $Z_{in}$ = 156.4Ω. From these results, it is understood that the input impedance $Z_{in}$ of the entire wireless power transmission apparatus 1 rises with an increase in the load $R_L$. Therefore, when the power-source frequency is set on the low frequency side (f(Low P)), the input current to the wireless power transmission apparatus 1 including the target device 10 is reduced with an increase in the load $R_L$, thus reducing the power consumption in the wireless power transmission apparatus 1 including the target device 10.

Further, the power-source frequency was set in the peak band on the High frequency side (f(High P)). When the $R_L$ = 50Ω, the input impedance $Z_{in}$ = 170.5Ω. When the $R_L$ = 100Ω, the input impedance $Z_{in}$ = 172.2Ω. When the $R_L$ = 200Ω, the input impedance $Z_{in}$ = 181.9Ω. From these results, it is understood that the input impedance $Z_{in}$ of the entire wireless power transmission apparatus 1 rises with an increase in the load $R_L$. Therefore, when the power-source frequency is set on the high frequency side (f(High P)), the input current to the wireless power transmission apparatus 1 including the target device 10 is reduced with an increase in the load $R_L$, thus reducing the power consumption in the wireless power transmission apparatus 1 including the target device 10.

In Example 4, measurement was conducted while simulating load fluctuation in the load impedance $Z_L$ within a range of 50Ω to 200Ω, by switching the load of the target device 10 among three values that are 50Ω, 100Ω, and 200Ω. With the maximum value of 200Ω at the range of load fluctuation, the input impedance $Z_{in}$ of the wireless power transmission apparatus 1 including the target device 10 exhibited two peak bands (see the resulting curve of 200Ω in the graph of FIG. 13B showing the input impedance with respect to the power-source frequency). Further, in Example 4, the input impedance $Z_{in}$ of the wireless power transmission apparatus 1 including the target device 10 with respect to the power-source frequency exhibited only one peak band with the loads of 50Ω and 100Ω, when the distance d12 between the power-supplying coil 21 and the power-supplying resonator 22 and the distance d34 between the power-receiving resonator 32 and the power-receiving coil 31 were both set to 10 mm (see FIG. 13B).

(Comparative Example)

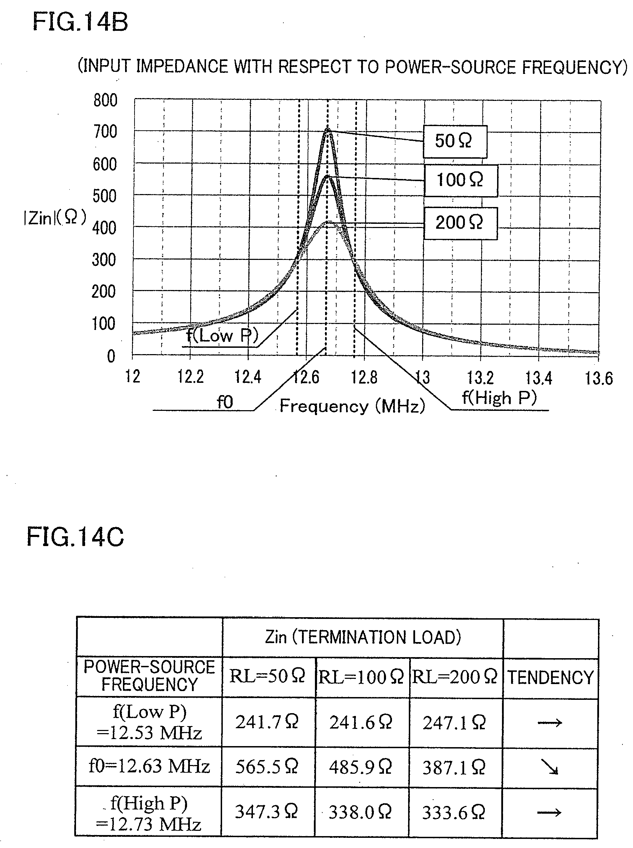

In Comparative Example, the distance d12 between the power-supplying coil 21 and the power-supplying resonator 22 was set to 5 mm, and the distance d34 between the power-receiving resonator 32 and the power-receiving coil 31 was set to 5 mm. The value of the variable resistor ($R_L$) was switched among three values; 50Ω, 100Ω, and 200Ω. With these conditions, the value of the input impedance $Z_{in}$ of the wireless power transmission apparatus 1 including the variable resistor (corresponding to the target device 10), with respect to the power-source frequency of the power (see FIG. 14B). The table in FIG. 14C collectively shows: measurement values in cases of setting the power-source frequency of AC power supplied to the power-supplying module 2 in the peak band (f(Low P)) on the low frequency side (inphase resonance mode: 12.53 MHz); measurement values in cases of setting the power-source frequency to the resonance frequency f0 (resonance frequency 12.63 MHz); and measurement values in cases of setting the power-source frequency in the peak band (f(High P)) on the high frequency side (antiphase resonance mode: 12.73 MHz). It should be noted that Comparative Example conducted measurement of the transmission characteristic "S21" with respect to the power-source frequency of the power, in the power-supplying resonator 22 and the power-receiving resonator 32 (solid line 150), as well as the transmission characteristic "S21" in the power-supplying coil 21, the power-supplying resonator 22, the power-receiving resonator 32, and the power-receiving coil 31 (solid line 155), as shown in FIG. 14A. The measurement results are shown in FIG. 14A.

As shown in FIG. 14B, the power-source frequency was set to the resonance frequency f0. When the $R_L$ = 50$\Omega$, the input impedance $Z_{in}$ = 565.5$\Omega$. When the $R_L$ = 100$\Omega$, the input impedance $Z_{in}$ = 485.9$\Omega$. When the $R_L$ = 200$\Omega$, the input impedance $Z_{in}$ = 387.1$\Omega$. From these results, it is understood that the input impedance $Z_{in}$ of the entire wireless power transmission apparatus 1 drops with an increase in the load $R_L$. Therefore, when the power-source frequency is set to the resonance frequency f0, the input current to the wireless power transmission apparatus 1 including the target device 10 increases with an increase in the load $R_L$, thus increasing the power consumption in the wireless power transmission apparatus 1 including the target device 10.

Then, the power-source frequency was set in the peak band on the low frequency side (f(Low P)). When the $R_L$ = 50$\Omega$, the input impedance $Z_{in}$ = 241.7$\Omega$. When the $R_L$ = 100$\Omega$, the input impedance $Z_{in}$ = 241.6$\Omega$. When the $R_L$ = 200$\Omega$, the input impedance $Z_{in}$ = 247.1$\Omega$. From these results, it is understood that the input impedance $Z_{in}$ of the entire wireless power transmission apparatus 1 indicated substantially the same values even with an increase in the load $R_L$. This means that the input current to the wireless power transmission apparatus 1 including the target device 10 result in little change even when the load $R_L$ rises, if the power-source frequency is set in the peak band on the low frequency side (f(Low P)).

Further, the power-source frequency was set in the peak band on the High frequency side (f(High P)). When the $R_L$ = 50$\Omega$, the input impedance $Z_{in}$ = 347.3$\Omega$. When the $R_L$ = 100$\Omega$, the input impedance $Z_{in}$ = 338.0$\Omega$. When the $R_L$ = 200$\Omega$, the input impedance $Z_{in}$ = 333.6$\Omega$. From these results, it is understood that the input impedance $Z_{in}$ of the entire wireless power transmission apparatus 1 rises with an increase in the load $R_L$. Therefore, when the power-source frequency is set in the peak band on the high frequency side (f(High P)), the input current to the wireless power transmission apparatus 1 including the target device 10 increases with an increase in the load $R_L$, thus increasing the power consumption in the wireless power transmission apparatus 1 including the target device 10.

In Comparative Example, measurement was conducted while simulating load fluctuation in the load impedance $Z_L$ within a range of 50$\Omega$ to 200$\Omega$ by switching the load of the target device 10 among three values that are 50$\Omega$, 100$\Omega$, and 200$\Omega$. With the maximum value of 200$\Omega$ at the range of load fluctuation, the input impedance $Z_{in}$ of the wireless power transmission apparatus 1 including the target device 10 exhibited only one peak band (see the resulting curve or 200$\Omega$ in the graph of FIG. 14B showing the input impedance with respect to the power-source frequency). It should be noted the input impedance $Z_{in}$ of the wireless power transmission apparatus 1 including the target device 10 with respect to the power-source frequency also exhibited only one peak band, when the load was set to 50$\Omega$ and 100$\Omega$ (see FIG. 14B).

As described above, when Examples 1 to 4 and Comparative Example are compared with one another, it is understood that the input impedance $Z_{in}$ of the entire wireless power transmission apparatus 1 rises with an increase in the load $R_L$, by carrying out setting so that the transmission characteristic "S21" with respect to power-source frequency of power, in the power-supplying resonator 22 and the power-receiving resonator 32, has two peak bands; setting the power-source frequency of power to be supplied to the power-supplying module 2 to a power-source frequency band corresponding to any of the two peak bands of the transmission characteristic "S21" (set to f(Low P) or f(High P)); and carrying out setting so that, when the load in the target device 10 is at its maximum value within its load fluctuation range (200$\Omega$ in Examples 1 to 4), the input impedance $Z_{in}$ of the wireless power transmission apparatus 1 including the target device 10, with respect to at least the power-source frequency of the power has two peak bands. Therefore, when the power-source frequency is set in the peak band on the high frequency side (f(High P)) or on the low frequency side (f(LowP)), the input current to the wireless power transmission apparatus 1 including the target device 10 is reduced with an increase in the load $R_L$, thus reducing the power consumption in the wireless power transmission apparatus 1 including the target device 10.

Further, based on Examples 1 to 4 and Comparative Example, when the power-source frequency is set to the resonance frequency f0, the input impedance $Z_{in}$ of the entire wireless power transmission apparatus 1 drops, and the input current to the wireless power transmission apparatus 1 including the target device 10 increases, with an increase in the load $R_L$, thus increasing the power consumption in the wireless power transmission apparatus 1 including the target device 10. This shows that the power-source frequency of power to be supplied to the power-supplying module 2 with respect to the transmission characteristic "S21" needs to be set to a power-source frequency band corresponding to any of the two peak bands (f(High P) or f(Low P)) of the transmission characteristic.

(Effects)

With the above structure, the value of the input impedance $Z_{in}$ of the entire wireless power transmission apparatus 1 including the target device 10 is varied according to the fluctuation tendency of the load of the target device 10, when the load of the target device 10 is varied. For example, when the load of the target device 10 rises, it is possible to raise the value of input impedance of the entire wireless power transmission apparatus 1 including the target device 10. Thus, when the load of the target device 10 rises, the input current to the wireless power transmission apparatus 1 including the target device 10 is reduced. This enables reduction of the power consumption when the load of the target device 10 is increased.

Further, the above structure allows a setting that achieves two peak bands in the transmission characteristic "S21" with respect to the power-source frequency of power in the power-supplying resonator 22 and the power-receiving resonator 32, and two peak bands in the input impedance $Z_{in}$ of the wireless power transmission apparatus 1, by mutually adjusting element values of circuit elements constituting the power-supplying module 2 and the power-receiving module 3.

The above structure allows a setting that achieve two peak bands in the transmission characteristic "S21" with respect to the power-source frequency of power in the power-supplying resonator 22 and the power-receiving resonator 32 and two peak bands in the input impedance $Z_{in}$ of the wireless power transmission apparatus 1 with respect to the power-source frequency of the power, by varying the values of the coupling coefficients $k_{12}$, $k_{23}$, $k_{34}$ between coils constituting the power-supplying module 2 and the power-receiving module 3.

Further, the above structure enables adjustment of the coupling coefficients $k_{12}$, $k_{23}$, $k_{34}$ between coils of the power-supplying module 2 and the power-receiving module 3, by varying the distances between coils. As such, the adjustment is possible with a simple designing of varying the distances between coils.

Further, in the above structure, the power-source frequency of the power supplied to the power-supplying module 2 is set to a frequency band corresponding to a peak band (f(High P)), out of the two peak bands of the transmission characteristic "S21", on the high frequency side. This enables formation of a magnetic field space G1 between the power-supplying resonator 22 and the power-receiving resonator 32, the magnetic field space G1 having a magnetic field strength smaller than the strength of the nearby magnetic field.

Further, in the above structure, the power-source frequency of the power supplied to the power-supplying module 2 is set to a frequency band corresponding to a peak band (f(Low P)), out of the two peak bands of the transmission characteristic "S21", on the low frequency side. This enables formation of a magnetic field space G2 outside the power-supplying resonator 22 and the power-receiving resonator 32, the magnetic field space G2 having a magnetic field strength smaller than the strength of the nearby magnetic field.

(Manufacturing Method)

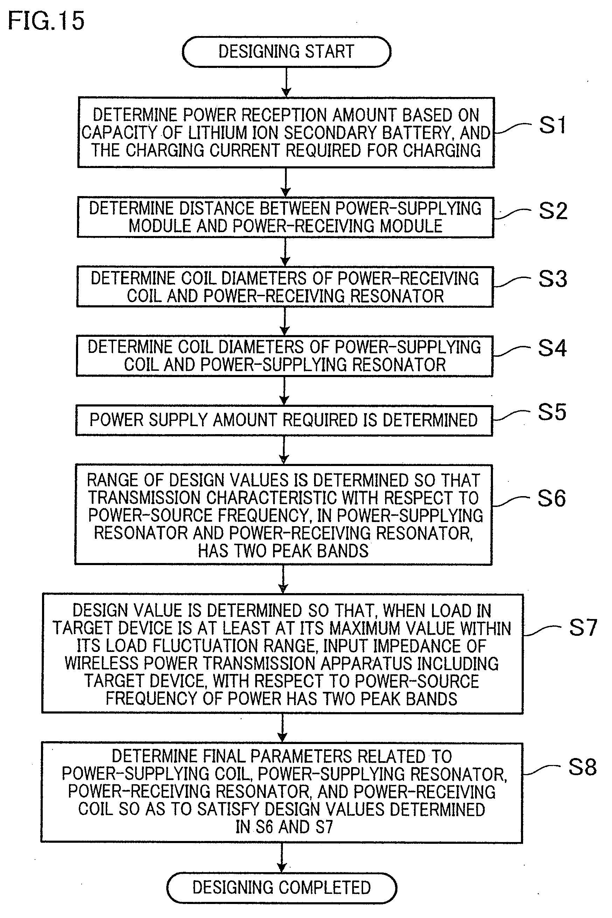

Next, the following describes with reference to FIG. 1 and FIG. 15 a design method (design process) which is a part of manufacturing process of the wireless power transmission apparatus 1. In the following description, an RF headset 102 and a charger 101 are described as a portable device having the wireless power transmission apparatus 1 (see FIG. 1).

(Design Method)

First, as shown in FIG. 15, a power reception amount in the power-receiving module 3 is determined based on the capacity of the lithium ion secondary battery 9, and the charging current required for charging the lithium ion secondary battery 9 (S1).

Next, the distance between the power-supplying module 2 and the power-receiving module 3 is determined (S2). The distance is the distance d23 between the power-supplying resonator 22 and the power-receiving resonator 32, while the RF headset 102 having therein the power-receiving module 3 is placed on the charger 101 having therein the power-supplying module 2, i.e., during the charging state. To be more specific, the distance d23 between the power-supplying resonator 22 and the power-receiving resonator 32 is determined, taking into account the shapes and the structures of the RF headset 102 and the charger 101.

Further, based on the shape and the structure of the RF headset 102, the coil diameters of the power-receiving coil 31 in the power-receiving module 3 and the coil of the power-receiving resonator 32 are determined (S3).

Further, based on the shape and the structure of the charger 101, the coil diameters of the power-supplying coil 21 in the power-supplying module 2 and the coil of the power-supplying resonator 22 are determined (S4).

Through the steps of S2 to S4, the coupling coefficient $K_{23}$ and the power transmission efficiency between the power-supplying resonator 22 (coil $L_2$) of the wireless power transmission apparatus 1 and the power-receiving resonator 32 (coil $L_3$) are determined.

Based on the power reception amount in the power-receiving module 3 determined in S1 and on the power transmission efficiency determined through S2 to S4, the minimum power supply amount required for the power-supplying module 2 is determined (S5).

Then, a range of the design values of the transmission characteristic "S21" with respect to the power-source frequency in the power-supplying resonator 22 and the power-receiving resonator 32 is determined, taking into account the power reception amount in the power-receiving module 3, the power transmission efficiency, and the minimum power supply amount required to the power-supplying module 2 (S6).

Further, setting values are determined such that, when the load in the target device 10; i.e., the stabilizer circuit 7, the charging circuit 8, and the lithium ion secondary battery 9 is at its maximum value within its possible load fluctuation range, the input impedance $Z_{in}$ of the wireless power transmission apparatus 1 including the target device 10, with respect to the power-source frequency of the power has at least two peak bands(S7).

With a design such that, when the load in the target device 10 is at its maximum value within its load fluctuation range, the input impedance $Z_{in}$ of the wireless power transmission apparatus 1 including the target device 10, with respect to the power-source frequency of the power has at least two peak bands, the degree of freedom is improved as compared with a case of designing such that the input impedance $Z_{in}$ of the wireless power transmission apparatus 1 including the target device 10 with respect to the power-source frequency, for the entire load fluctuation range (or for some range within the load fluctuation range) predictable in the target device 10.

Then, final parameters related to the power-supplying coil 21, the power-supplying resonator 22, the power-receiving resonator 32, and the power-receiving coil 31 are determined so as to satisfy the design values determined in S5 and S7 (S8). The parameters related to the power-supplying coil 21, the power-supplying resonator 22, the power-receiving resonator 32, and the power-receiving coil 31 include: the resistance value, inductance, capacity of capacitor, and the coupling coefficients $K_{12}$, $K_{23}$, $K_{34}$ in the $R_1$ and $L_1$ of the RL circuit of the power-supplying coil 21, the $R_2$, $L_2$, and $C_2$ of the RLC circuit of the power-supplying resonator 22, the $R_3$, $L_3$, and $C_3$ of the RLC circuit of the power-receiving resonator 32, and the $R_4$ and $L_4$ of the RLC circuit of the power-receiving coil 31; the distance d12 between the power-supplying coil 21 and the power-supplying resonator 22; and the distance between the power-receiving resonator 32 and the power-receiving coil 31. It should be noted that when an RLC circuit is adopted as the power-supplying coil 21 and the power-receiving coil 31, the capacity of the capacitor in each RLC circuit also serves as a parameter variable at the stage of designing and manufacturing.

(Other Embodiments)

Although the above description of the manufacturing method deals with an RF headset 102 as an example, the method is applicable to any devices in which load fluctuation takes place; e.g., tablet PCs, digital cameras, mobile phone phones, earphone-type music player, hearing aids, and sound collectors.

Although the above description deals with a wireless power transmission apparatus 1 configured to perform power transmission by means of magnetic coupling using a resonance phenomenon (magnetic field resonant state) between resonators (coils) provided to a power-supplying module 2 and a power-receiving module 3, the present invention is applicable to a wireless power transmission apparatus 1 configured to perform power transmission by using electromagnetic induction between coils.

Further, although the above description assumes the wireless power transmission apparatus 1 is mounted in a portable electronic device, the use of such an apparatus is not limited to small devices. For example, with a modification to the specifications according to the required power amount, the wireless power transmission apparatus 1 is mountable to a relatively large system such as a wireless charging system in an electronic vehicle (EV), or to an even smaller device such as a wireless endoscope for medical use.

Although the above descriptions have been provided with regard to the characteristic parts so as to understand the present invention more easily, the invention is not limited to the embodiments and the examples as described above and can be applied to the other embodiments and examples, and the applicable scope should be construed as broadly as possible. Furthermore, the terms and phraseology used in the specification have been used to correctly illustrate the present invention, not to limit it. In addition, it will be understood by those skilled in the art that the other structures, systems, methods and the like included in the spirit of the present invention can be easily derived from the spirit of the invention described in the specification. Accordingly, it should be considered that the present invention covers equivalent structures thereof without departing from the spirit and scope of the invention as defined in the following claims. In addition, it is required to sufficiently refer to the documents that have been already disclosed, so as to fully understand the objects and effects of the present invention.

Reference Signs List

1. Wireless Power Transmission Apparatus
2. Power-Supplying Module
3. Power-Receiving Module
6. AC Power Source
7. Stabilizer Circuit
8. Charging Circuit
9. Lithium Ion Secondary Battery
10. Target Device (Device to be Powered)
21. Power-Supplying Coil
22. Power-Supplying Resonator
31. Power-Receiving Coil
32. Power-Receiving Resonator
101. Charger
102. RF Headset
G1, G2. Magnetic Field Space

## Claims

1. A wireless power transmission apparatus, configured to supply power from a power-supplying module to a power-receiving module by varying a magnetic field, the power-supplying module comprising at least a power-supplying resonator, the power-receiving module comprising at least a power-receiving resonator, the power-receiving module connected to a device to be powered with variable load, wherein

   a transmission characteristic, of the power-supplying resonator and the power-receiving resonator, with respect to the power-source frequency of the power has two peak bands, and the power-source frequency of the power supplied to the power-supplying module is set to a power-source frequency band corresponding to either one of the two peak bands of the transmission characteristic, and

   setting is carried out so that, when the load in the device to be powered is at its maximum value within its load fluctuation range, the input impedance of the wireless power transmission apparatus including the device to be powered, with respect to the power-source frequency of the power has at least two peak bands.

2. The wireless power transmission apparatus according to claim 1, wherein
   element values of a plurality of circuit elements constituting the power-supplying module and the power-receiving module are used as parameters, and the parameters are varied so that the transmission characteristic with respect to the power-source frequency of the power in the power-supplying resonator and the power-receiving resonator has two peak bands, and that the input impedance of the wireless power transmission apparatus including the device to be powered with respect to the power-source frequency of the power has two peak bands.

3. The wireless power transmission apparatus according to claim 1, wherein
   coupling coefficients between coils of the power-supplying module and the power-receiving module are adjusted so that the transmission characteristic with respect to the power-source frequency of the power in the power-supplying resonator and the power-receiving resonator has two peak bands, and that the input impedance of the wireless power transmission apparatus including the device to be powered with respect to the power-source frequency of the power has two peak bands.

4. The wireless power transmission apparatus according to claim 3, wherein
   the values of the coupling coefficients between the coils of the power-supplying module and the power-receiving module are adjusted by varying distances between the coils.

5. The wireless power transmission apparatus according to claim 1, wherein
   the power-source frequency of the power supplied to the power-supplying module is set to a frequency band corresponding to a peak band, out of the two peak bands of the transmission characteristic, on the high frequency side.

6. The wireless power transmission apparatus according to claim 1, wherein
   the power-source frequency of the power supplied to the power-supplying module is set to a frequency band corresponding to a peak band, out of the two peak bands of the transmission characteristic, on the low frequency side.

7. A manufacturing method of a wireless power transmission apparatus configured to supply power from a power-supplying module to a power-receiving module by varying a magnetic field, the power-supplying module comprising at least a power-supplying resonator, the power-receiving module comprising at least a power-receiving resonator, the power-receiving module connected to a device to be powered with variable load, the method comprising:

carrying out setting so that a transmission characteristic with respect to the power-source frequency of the power, in the power-supplying resonator and the power-receiving resonator, has two peak bands; and
carrying out setting so that, when the load in the device to be powered is at its maximum value within its load fluctuation range, the input impedance of the wireless power transmission apparatus including the device to be powered with respect to the power-source frequency of the power has at least two peak bands.

FIG.1

FIG.2

$$I_{in} = V_{in} / Z_{in}$$

FIG.3

# FIG.4

(GRAPH WHERE TRANSMISSION CHARACTERISTIC
"S21" BETWEEN RESONATORS EXHIBITS TWO PEAKS)

FIG.5

MEASUREMENT OF TRANSMISSION CHARACTERISTIC "S21" BETWEEN POWER-SUPPLYING RESONATOR 22 AND POWER-RECEIVING RESONATOR 32

FIG.6

FIG.7

FIG.8A

FIG.8B

## FIG.9

COUPLING
COEFFICIENT k

0

INTER-COIL
DISTANCE

## FIG.10A

(EXAMPLE 1)
(MEASUREMENT RESULT OF "S21")

f0

f(Low P)

f(High P)

S21(dB)

151

150

Frequency (MHz)

## FIG.10B

(INPUT IMPEDANCE WITH RESPECT TO POWER-SOURCE FREQUENCY)

## FIG.10C

| | Zin (TERMINATION LOAD) | | | |
|---|---|---|---|---|
| POWER-SOURCE FREQUENCY | RL=50 Ω | RL=100 Ω | RL=200 Ω | TENDENCY |
| f(Low P) =12.53 MHz | 40.6 Ω | 41.8 Ω | 43.1 Ω | ↗ |
| f0=12.63 MHz | 25.0 Ω | 24.4 Ω | 23.9 Ω | ↘ |
| f(High P) =12.73 MHz | 32.7 Ω | 35.6 Ω | 37.3 Ω | ↗ |

## FIG.11A

(EXAMPLE 2)
  (MEASUREMENT RESULT OF "S21")

## FIG.11B

(INPUT IMPEDANCE WITH RESPECT TO POWER-SOURCE FREQUENCY)

# FIG.11C

| | Zin (TERMINATION LOAD) | | | |
|---|---|---|---|---|
| POWER-SOURCE FREQUENCY | RL=50 Ω | RL=100 Ω | RL=200 Ω | TENDENCY |
| f(Low P) =12.53 MHz | 55.2 Ω | 57.5 Ω | 60.4 Ω | ↗ |
| f0=12.63 MHz | 33.5 Ω | 29.0 Ω | 26.7 Ω | ↘ |
| f(High P) =12.73 MHz | 40.0 Ω | 47.4 Ω | 52.4 Ω | ↗ |

# FIG.12A

(EXAMPLE 3)
(MEASUREMENT RESULT OF "S21")

## FIG.12B

(INPUT IMPEDANCE WITH RESPECT TO POWER-SOURCE FREQUENCY)

## FIG.12C

| | Zin (TERMINATION LOAD) | | | |
|---|---|---|---|---|
| POWER-SOURCE FREQUENCY | RL=50 Ω | RL=100 Ω | RL=200 Ω | TENDENCY |
| f(Low P) =12.53 MHz | 74.3 Ω | 77.7 Ω | 84.1 Ω | ↗ |
| f0=12.63 MHz | 84.8 Ω | 63.0 Ω | 48.5 Ω | ↘ |
| f(High P) =12.73 MHz | 61.3 Ω | 74.7 Ω | 87.0 Ω | ↗ |

# FIG.13A

(EXAMPLE 4)
(MEASUREMENT RESULT OF "S21")

# FIG.13B

(INPUT IMPEDANCE WITH RESPECT TO POWER-SOURCE FREQUENCY)

## FIG.13C

| POWER-SOURCE FREQUENCY | Zin (TERMINATION LOAD) | | | TENDENCY |
|---|---|---|---|---|
| | RL=50 Ω | RL=100 Ω | RL=200 Ω | |
| f(Low P) =12.53 MHz | 144.1 Ω | 146.5 Ω | 156.4 Ω | ↗ |
| f0=12.63 MHz | 267.4 Ω | 203.5 Ω | 149.5 Ω | ↘ |
| f(High P) =12.73 MHz | 170.5 Ω | 172.2 Ω | 181.9 Ω | ↗ |

## FIG.14A

(COMPARATIVE EXAMPLE )

(MEASUREMENT RESULT OF "S21")

## FIG.14B

(INPUT IMPEDANCE WITH RESPECT TO POWER-SOURCE FREQUENCY)

## FIG.14C

| | Zin (TERMINATION LOAD) | | | |
|---|---|---|---|---|
| POWER-SOURCE FREQUENCY | RL=50 Ω | RL=100 Ω | RL=200 Ω | TENDENCY |
| f(Low P) =12.53 MHz | 241.7 Ω | 241.6 Ω | 247.1 Ω | → |
| f0=12.63 MHz | 565.5 Ω | 485.9 Ω | 387.1 Ω | ↘ |
| f(High P) =12.73 MHz | 347.3 Ω | 338.0 Ω | 333.6 Ω | → |

# FIG.15

```
┌─────────────────────────┐
│     DESIGNING START     │
└─────────────────────────┘
             │
             ▼
┌───────────────────────────────────────────────┐
│ DETERMINE POWER RECEPTION AMOUNT BASED ON      │── S1
│ CAPACITY OF LITHIUM ION SECONDARY BATTERY, AND │
│ THE CHARGING CURRENT REQUIRED FOR CHARGING     │
└───────────────────────────────────────────────┘
             │
             ▼
┌───────────────────────────────────────────────┐
│ DETERMINE DISTANCE BETWEEN POWER-SUPPLYING     │── S2
│ MODULE AND POWER-RECEIVING MODULE              │
└───────────────────────────────────────────────┘
             │
             ▼
┌───────────────────────────────────────────────┐
│ DETERMINE COIL DIAMETERS OF POWER-RECEIVING    │── S3
│ COIL AND POWER-RECEIVING RESONATOR             │
└───────────────────────────────────────────────┘
             │
             ▼
┌───────────────────────────────────────────────┐
│ DETERMINE COIL DIAMETERS OF POWER-SUPPLYING    │── S4
│ COIL AND POWER-SUPPLYING RESONATOR             │
└───────────────────────────────────────────────┘
             │
             ▼
┌───────────────────────────────────────────────┐
│ POWER SUPPLY AMOUNT REQUIRED IS DETERMINED     │── S5
└───────────────────────────────────────────────┘
             │
             ▼
┌───────────────────────────────────────────────┐
│ RANGE OF DESIGN VALUES IS DETERMINED SO THAT   │── S6
│ TRANSMISSION CHARACTERISTIC WITH RESPECT TO    │
│ POWER-SOURCE FREQUENCY, IN POWER-SUPPLYING     │
│ RESONATOR AND POWER-RECEIVING RESONATOR,       │
│ HAS TWO PEAK BANDS                             │
└───────────────────────────────────────────────┘
             │
             ▼
┌───────────────────────────────────────────────┐
│ DESIGN VALUE IS DETERMINED SO THAT, WHEN LOAD IN│── S7
│ TARGET DEVICE IS AT LEAST AT ITS MAXIMUM VALUE WITHIN│
│ ITS LOAD FLUCTUATION RANGE, INPUT IMPEDANCE OF │
│ WIRELESS POWER TRANSMISSION APPARATUS INCLUDING│
│ TARGET DEVICE, WITH RESPECT TO POWER-SOURCE    │
│ FREQUENCY OF POWER HAS TWO PEAK BANDS          │
└───────────────────────────────────────────────┘
             │
             ▼
┌───────────────────────────────────────────────┐
│ DETERMINE FINAL PARAMETERS RELATED TO          │── S8
│ POWER-SUPPLYING COIL, POWER-SUPPLYING RESONATOR,│
│ POWER-RECEIVING RESONATOR, AND POWER-RECEIVING │
│ COIL SO AS TO SATISFY DESIGN VALUES DETERMINED │
│ IN S6 AND S7                                   │
└───────────────────────────────────────────────┘
             │
             ▼
┌─────────────────────────┐
│   DESIGNING COMPLETED   │
└─────────────────────────┘
```

## INTERNATIONAL SEARCH REPORT

| International application No. |
| --- |
| PCT/JP2015/050655 |

### A. CLASSIFICATION OF SUBJECT MATTER
*H02J17/00*(2006.01)i

According to International Patent Classification (IPC) or to both national classification and IPC

### B. FIELDS SEARCHED

Minimum documentation searched (classification system followed by classification symbols)
H02J17/00

Documentation searched other than minimum documentation to the extent that such documents are included in the fields searched
Jitsuyo Shinan Koho        1922–1996    Jitsuyo Shinan Toroku Koho    1996–2015
Kokai Jitsuyo Shinan Koho  1971–2015    Toroku Jitsuyo Shinan Koho    1994–2015

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| Y | JP 2013-017254 A  (Equos Research Co., Ltd.), 24 January 2013 (24.01.2013), paragraphs [0012] to [0037], [0046] to [0086]; fig. 1 to 5, 8 to 15 & US 2014/0111022 A1    & WO 2013/002319 A1 & EP 2728709 A1 | 1-7 |
| Y | JP 2011-147213 A  (Toyota Motor Corp., Nagoya Institute of Technology), 28 July 2011 (28.07.2011), paragraphs [0016] to [0032], [0061] to [0062], [0071] to [0072], [0105]; fig. 5, 9 & US 2012/0326499 A1    & WO 2011/086445 A2 & CN 102712267 A | 1-7 |

☒ Further documents are listed in the continuation of Box C.       ☐ See patent family annex.

| | |
| --- | --- |
| * | Special categories of cited documents: |
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 27 March 2015 (27.03.15) | 07 April 2015 (07.04.15) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (July 2009)

**INTERNATIONAL SEARCH REPORT**

International application No.

PCT/JP2015/050655

C (Continuation).　DOCUMENTS CONSIDERED TO BE RELEVANT

| Category* | Citation of document, with indication, where appropriate, of the relevant passages | Relevant to claim No. |
|---|---|---|
| Y | JP 2013-188016 A (Hitachi Maxell, Ltd.), 19 September 2013 (19.09.2013), paragraphs [0006] to [0008]; fig. 10 to 11 & US 2013/0234529 A1 | 3,4 |
| Y | JP 2010-239838 A (Fujitsu Ltd.), 21 October 2010 (21.10.2010), paragraph [0051]; fig. 5 & US 2010/0244839 A1 | 6 |
| A | JP 2013-240260 A (Nitto Denko Corp.), 28 November 2013 (28.11.2013), entire text; all drawings & WO 2014/080647 A1 | 1-7 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4624768 B

- JP 2013239692 A